(19) Europäisches Patentamt / European Patent Office / Office européen des brevets

(11) **EP 3 462 555 B1**

(12) **FASCICULE DE BREVET EUROPEEN**

(45) Date de publication et mention de la délivrance du brevet:
**13.05.2020 Bulletin 2020/20**

(51) Int Cl.:
**H01S 5/30** (2006.01)

(21) Numéro de dépôt: **18196491.7**

(22) Date de dépôt: **25.09.2018**

(54) **SOURCE LASER A MEMBRANE SUSPENDUE A BASE DE GERMANIUM ET GUIDE D'ONDE INTEGRE PARTICIPANT A FORMER LA CAVITE OPTIQUE**

LASERQUELLE MIT HÄNGEMEMBRAN AUF DER BASIS VON GERMANIUM, UND INTEGRIERTER WELLENLEITER, DER AN DER BILDUNG DES OPTISCHEN HOHLRAUMS BETEILIGT IST

LASER SOURCE WITH A GERMANIUM BASED SUSPENDED MEMBRANE AND INTEGRATED WAVEGUIDE CONTRIBUTING TO FORMING THE OPTICAL CAVITY

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **28.09.2017 FR 1759017**

(43) Date de publication de la demande:
**03.04.2019 Bulletin 2019/14**

(73) Titulaire: **Commissariat à l'Énergie Atomique et aux Énergies Alternatives**
75015 Paris (FR)

(72) Inventeurs:
• **REBOUD, Vincent**
75013 PARIS (FR)
• **BOUTAMI, Salim**
38100 GRENOBLE (FR)

(74) Mandataire: **GIE Innovation Competence Group**
310, avenue Berthelot
69372 Lyon Cedex 08 (FR)

(56) Documents cités:
**EP-A1- 3 151 266**

• **GUPTA SHASHANK ET AL: "A novel, highly-strained structure with an integrated optical cavity for a low threshold germanium laser", 2015 CONFERENCE ON LASERS AND ELECTRO-OPTICS (CLEO), OSA, 10 mai 2015 (2015-05-10), pages 1-2, XP033194117,**
• **JAN PETYKIEWICZ ET AL: "Direct Bandgap Light Emission from Strained Germanium Nanowires Coupled with High-Q Nanophotonic Cavities", NANO LETTERS, vol. 16, no. 4, 2 mars 2016 (2016-03-02), pages 2168-2173, XP055482163, US ISSN: 1530-6984, DOI: 10.1021/acs.nanolett.5b03976**
• **CICEK BOZTUG ET AL: "Strained-Germanium Nanostructures for Infrared Photonics", ACS NANO, vol. 8, no. 4, 22 avril 2014 (2014-04-22), pages 3136-3151, XP055482595, US ISSN: 1936-0851, DOI: 10.1021/nn404739b**

## Description

## DOMAINE TECHNIQUE

Le domaine de l'invention est celui des sources laser comportant une membrane suspendue réalisée à base de germanium, dont le milieu d'amplification optique est situé dans une portion centrale mise en tension par des bras tenseurs.

## ÉTAT DE LA TECHNIQUE ANTÉRIEURE

Dans diverses applications microélectroniques ou optoélectroniques, il peut être avantageux d'utiliser une couche en un composé semiconducteur cristallin, de préférence monocristallin, présentant une contrainte mécanique en tension. C'est le cas notamment de certaines sources de lumière dont le matériau d'amplification optique présente, hors contrainte, une structure de bandes d'énergie indirecte, la structure de bandes étant alors rendue directe par l'application d'une contrainte en tension suffisante. Le composé semiconducteur cristallin peut être un composé à base de germanium, par exemple du germanium, du germanium étain, voire du silicium germanium.

EP 3 151 266 A1 divulgue une source laser comportant une couche semiconductrice réalisée à base de germanium.

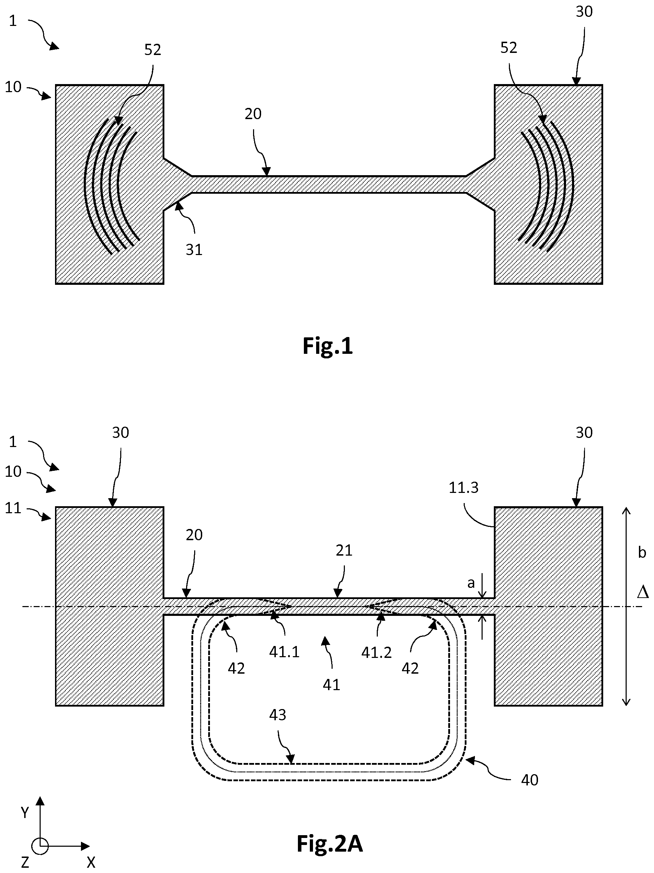

La figure 1 illustre schématiquement une source laser 1 à membrane suspendue selon un exemple de l'art antérieur, tel que décrit dans l'article de Petykiewicz et al. intitulé Direct Bandgap Light Emission from Strained Ge Nanowires, Nano Lett., 2016, 16 (4), 2168-2173. La source laser 1 comporte une couche semiconductrice 10 réalisée à base de germanium, celle-ci étant structurée pour former une membrane suspendue au-dessus d'une couche support. La membrane suspendue comporte une portion centrale 20 mise en tension par des portions latérales 30 formant des bras tenseurs. La portion centrale 20 forme le milieu d'amplification optique de la source laser 1, celui-ci étant situé dans une cavité optique définie par deux miroirs de Bragg 52. Ces derniers, disposés dans les bras tenseurs 30, sont formés par une succession périodique de gravures localisées de la couche semiconductrice 10.

Il existe cependant un besoin de disposer d'une source laser à membrane suspendue à base de germanium dont les propriétés mécaniques de la membrane suspendue sont améliorées. Il existe également un besoin de disposer d'une telle source laser dont les propriétés optiques et/ou électroniques de la membrane suspendue sont améliorées.

## EXPOSÉ DE L'INVENTION

L'invention a pour objectif de remédier au moins en partie aux inconvénients de l'art antérieur, et de proposer une source laser dont les propriétés mécaniques de la membrane suspendue sont améliorées, ainsi que les propriétés optiques et/ou électroniques de cette dernière.

Pour cela, l'objet de l'invention est une source laser comportant une couche semiconductrice réalisée à base de germanium, comportant une membrane suspendue au-dessus d'une couche support, la membrane suspendue étant formée :

- d'une portion centrale, contrainte en tension dans un plan parallèle à la couche support, comportant une section d'amplification optique adaptée à produire un rayonnement lumineux par émission stimulée ; et
- de plusieurs portions latérales formant des bras tenseurs, opposées les unes aux autres vis-à-vis de la portion centrale, et agencées de manière à maintenir la portion centrale suspendue et contrainte en tension, les bras tenseurs présentant une largeur moyenne supérieure à une largeur moyenne de la portion centrale.

Selon l'invention, la source laser comporte en outre un guide d'onde intégré, participant à former une cavité optique avec au moins la section d'amplification optique, situé au niveau de la couche support et à distance de la membrane suspendue, et comportant :

- une section de couplage, située en regard de la section d'amplification optique, adaptée à permettre le couplage optique à celle-ci par onde évanescente ; et
- au moins une section courbe, prolongeant la section de couplage, et agencée de sorte que le guide d'onde intégré soit disposé à distance, en projection orthogonale, des bras tenseurs.

Certains aspects préférés mais non limitatifs de cette source laser sont les suivants.

La source laser étant adaptée à émettre un rayonnement lumineux de longueur d'onde d'émission $\lambda$, le guide d'onde intégré peut présenter une distance minimale vis-à-vis des bras tenseurs, en projection orthogonale, supérieure ou égale à $\lambda/4$.

La section courbe peut présenter un rayon de courbure moyen supérieur ou égal à $\lambda/4$. Elle peut présenter un rayon de courbure moyen inférieur ou égal à $2\lambda$.

Le guide d'onde intégré peut présenter une forme longitudinale en anneau, et comporter deux sections courbes prolongeant la section de couplage et situées de part et d'autre de celui-ci, et une section dite distale, reliée à la section de couplage par les sections courbes.

Le guide d'onde intégré peut présenter une forme longitudinale dite ouverte. Il peut comporter une première section dite distale, reliée à la section de couplage par la section courbe et comprenant un premier réflecteur optique.

La source laser peut comporter un deuxième réflecteur optique situé dans un bras tenseur opposé au bras tenseur à proximité duquel est située la première section distale, de sorte que la cavité optique est définie par le premier réflecteur optique situé dans la première section distale et par le deuxième réflecteur optique situé dans le deuxième bras tenseur.

Le guide d'onde intégré peut comporter une deuxième section distale comprenant un deuxième réflecteur optique, distincte de la première section distale, et reliée à la section de couplage par une deuxième section courbe, de sorte que la cavité optique est définie par le premier réflecteur optique situé dans la première section distale et par le deuxième réflecteur optique situé dans la deuxième section distale.

La section de couplage peut comporter au moins une zone de couplage qui présente une dimension transversale qui varie suivant l'axe longitudinal du guide d'onde intégré, de sorte qu'un indice effectif du mode optique supporté par la section de couplage passe localement d'une valeur supérieure à un indice effectif du mode optique supporté par la section d'amplification optique à une valeur inférieure à celui-ci.

La zone de couplage peut former un transformateur de mode adiabatique.

La zone de couplage peut présenter un couplage partiel de manière à permettre une extraction du rayonnement lumineux hors de la cavité optique parla membrane suspendue, ou présente un couplage total de manière à permettre une extraction du rayonnement lumineux hors de la cavité optique au moyen d'un guide d'onde d'extraction situé au niveau de la couche support et couplé optiquement au guide d'onde intégré.

La membrane suspendue peut comporter deux zones dopées selon des types de conductivité opposés s'étendant au moins en partie dans les portions latérales de part et d'autre de la section d'amplification optique, celle-ci comportant un matériau non intentionnellement dopé ou dopé de type n.

Le guide d'onde intégré peut être situé à distance, en projection orthogonale, desdites zones dopées.

La portion centrale peut présenter des contraintes mécaniques moyennes en tension, d'une valeur suffisante pour rendre sensiblement directe sa structure de bandes d'énergie au niveau de la section d'amplification optique.

L'invention porte également sur un procédé de fabrication d'une source laser selon l'une quelconque des caractéristiques précédentes, comportant les étapes suivantes :

i. réalisation du guide d'onde intégré dans la couche support ;
ii. réalisation de la couche semiconductrice comportant la membrane formée de la portion centrale et des bras tenseurs, de sorte que la section de couplage soit située en regard de la section d'amplification optique et que les bras tenseurs soient situés à distance, en projection orthogonale, du guide d'onde intégré ;
iii. mise en suspension de la membrane, de sorte que la portion centrale soit contrainte en tension par les bras tenseurs.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1, déjà décrite, est une vue de dessus, schématique et partielle, d'une source laser à membrane suspendue selon un exemple de l'art antérieur, dans lequel la cavité optique est formée par des miroirs de Bragg situés dans les bras tenseurs ;

les figures 2A et 2B sont des vues de dessus et en coupe longitudinale, schématiques et partielles, d'une source laser à membrane suspendue selon un premier mode de réalisation, comportant une cavité optique en partie formée par un guide d'onde intégré en anneau ;

les figures 3A et 3B sont des vues en coupe longitudinale de la source laser selon le premier mode de réalisation, qui illustrent deux exemples de réalisation de la section suspendue d'amplification optique telle qu'illustrée sur la fig.2B ;

la fig.4 est une vue de dessus d'une partie de la source laser selon le premier mode de réalisation illustré sur la fig.2A, au niveau d'une section courbe du guide d'onde intégré ;

les figures 5A à 5C sont des vues de dessus, schématiques et partielles, de la source laser selon différentes variantes du premier mode de réalisation ;

les figures 6A à 6I sont des vues de dessus, schématiques et partielles, de différentes étapes de réalisation de la source laser selon le premier mode de réalisation illustré sur la fig.2A ;

les figures 7A et 7B sont des vues de dessus, schématiques et partielles, de deux variantes d'une source laser selon un deuxième mode de réalisation, dans lequel la source laser est de type DBR (pour *Distributed Bragg Reflector,* en anglais).

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près. Par ailleurs, l'expression « comportant un » doit être comprise comme « comportant au moins un », sauf indication contraire.

L'invention porte sur une source laser adaptée à émettre un rayonnement lumineux cohérent à une longueur d'onde d'émission λ.

La source laser comporte une membrane suspendue réalisée à base de germanium, la membrane comportant une portion centrale qui est suspendue et mise en tension par des portions latérales formant des bras tenseurs. La membrane suspendue est réalisée à base de germanium, celui-ci étant alors contraint en tension d'une manière suffisante pour permettre l'émission du rayonnement lumineux par recombinaison radiative de paires électron-trou. De préférence, la contrainte mécanique en tension est suffisante pour que la portion centrale présente, au moins sur une section longitudinale, une structure de bandes d'énergie directe.

La portion centrale comporte une section d'amplification optique dans laquelle est situé le milieu à gain, celle-ci étant disposée dans une cavité optique résonnante formée au moins en partie par un guide d'onde intégré. La cavité optique est alors formée par le guide d'onde intégré et par au moins la section d'amplification optique.

Ainsi, la cavité optique est dite hybride, dans la mesure où elle est formée en partie par le guide d'onde intégré d'une part, et au moins par la section d'amplification optique de la membrane suspendue d'autre part. Comme décrit plus loin, selon un premier mode de réalisation, la cavité optique est définie par l'anneau que forme le guide d'onde intégré. Et selon un deuxième mode de réalisation, la cavité optique est définie par des réflecteurs optiques, par exemple de type miroirs de Bragg, dont au moins l'un est situé dans une section dite distale du guide d'onde intégré. Dans ce cas, la cavité optique présente une forme longitudinale dite ouverte, par opposition à la forme longitudinale en anneau du premier mode de réalisation.

Le guide d'onde est dit intégré, dans la mesure où il est situé au niveau de la couche support au-dessus de laquelle est suspendue la membrane. Le guide d'onde intégré est alors situé à distance, suivant un axe orthogonal, de la membrane suspendue, et donc de la portion centrale. Il peut être situé dans la couche support et peut déboucher ou non sur la face supérieure de celle-ci. Il peut également être situé sur la face supérieure de la couche support.

La section suspendue d'amplification optique est couplée optiquement à une section dite de couplage du guide d'onde intégré par onde évanescente. Pour cela, la section de couplage est située en regard de la section d'amplification optique. Par en regard, on entend au droit, ou à la perpendiculaire. Le couplage optique est notamment permis par le fait que l'indice effectif du mode optique supporté par la section de couplage est, au moins localement, inférieur à l'indice effectif du mode optique supporté par la portion centrale, permettant ainsi le transfert, partiel ou total, du mode optique, de la section de couplage à la section suspendue d'amplification optique, et inversement.

De plus, le guide d'onde intégré comporte au moins une section courbe qui prolonge la section de couplage, et relie cette dernière à une section dite distale qui participe à former la cavité optique. La section courbe est agencée de sorte que le guide d'onde intégré soit situé à distance, en projection orthogonale, vis-à-vis des bras tenseurs. Il en est de même pour la section distale. Par projection orthogonale, on entend la projection, suivant un axe orthogonal, dans un plan suivant lequel s'étendent les bras tenseurs de la membrane suspendue. Ainsi, le guide d'onde intégré n'est pas situé sous par les bras tenseurs, et n'est donc pas recouvert par ceux-ci, même partiellement. En d'autres termes, en projection orthogonale dans le plan suivant lequel s'étend la membrane suspendue, le guide d'onde intégré est situé à une distance minimale non nulle vis-à-vis des bras tenseurs.

La couche semiconductrice de la membrane suspendue est réalisée à base de germanium, c'est-à-dire que le matériau semiconducteur cristallin, de préférence monocristallin, de la couche semiconductrice est en germanium et/ou en un ou plusieurs alliages à base de germanium, tels que, par exemple, le SiGe, le GeSn, le SiGeSn. De préférence, le matériau semiconducteur cristallin à base de germanium de la couche semiconductrice présente, en l'absence de déformation en tension de son réseau cristallin, une structure de bandes d'énergie indirecte. La déformation en tension subie par le matériau à base de germanium peut être suffisante pour que la structure de bandes de ce dernier soit au moins localement sensiblement directe. En variante, le matériau à base de germanium peut présenter, au moins localement, un niveau de dopage de type n et une déformation en tension qui soient suffisants pour permettre l'émission du rayonnement lumineux. Dans ce cas de figure, la déformation en tension et le dopage de type n permettent de peupler en électrons la vallée L (ou vallée indirecte) et au moins partiellement la vallée Γ (ou vallée directe). La recombinaison radiative entre les porteurs de charge situés dans la bande de valence et la vallée directe de la bande de conduction est alors possible.

Par portion contrainte, on entend une portion de couche réalisée en un composé semiconducteur cristallin présentant une contrainte mécanique en tension ou en compression, entraînant une déformation des mailles de son réseau cristallin. La portion est contrainte en tension lorsqu'elle subit une contrainte mécanique qui tend à étirer les mailles du réseau dans un plan. Dans le cadre de l'invention, la portion centrale de la membrane suspendue est contrainte en tension dans le plan de la couche semiconductrice, ce qui se traduit par le fait que son paramètre de maille présente une valeur dite effective supérieure à sa valeur naturelle lorsque le composé semiconducteur est relaxé (i.e. non contraint). Dans la suite de la description, sauf indication contraire, la contrainte considérée est orientée dans le plan de la couche semiconductrice.

Par structure de bandes directe ou sensiblement directe, on entend que le minimum d'énergie $E_{BC,L}$ de la bande de conduction de la vallée L (ou vallée indirecte) est supérieur ou sensiblement égal au minimum d'énergie $E_{BC,\Gamma}$ de la bande de conduction de la vallée $\Gamma$ (ou vallée directe), autrement dit : $\Delta E = E_{BC,L} - E_{BC,\Gamma} \geq 0$. Par sensiblement égal, on entend ici que cette différence d'énergie est de l'ordre de grandeur ou inférieure à kT, où k est la constante de Boltzmann et T la température du matériau. La couche semiconductrice est réalisée à base de germanium dont la structure de bandes d'énergie est indirecte en-dehors de la portion centrale de la membrane suspendue, autrement dit $\Delta E < 0$, et la portion centrale présente une déformation en tension suffisante pour, de préférence, rendre sa structure de bandes d'énergie directe au moins localement.

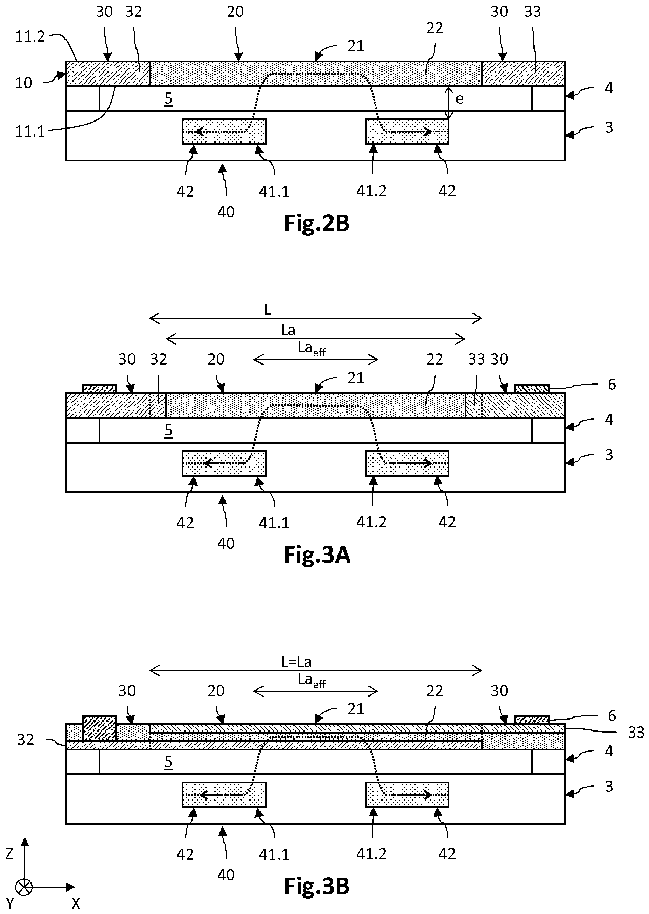

La figure 2A et 2B sont des vues partielles et schématiques d'un premier mode de réalisation d'une source laser 1 à membrane suspendue réalisée à base de germanium, comportant une cavité optique formée au moins en partie par un guide d'onde intégré 40 en anneau. La fig.2A est une vue de dessus et la fig.2B est une vue en coupe longitudinale suivant le plan de coupe XZ passant par l'axe $\Delta$.

On définit ici et pour la suite de la description un repère direct tridimensionnel (X,Y,Z), où les axes X et Y forment un plan parallèle au plan d'une couche support 3, et où l'axe Z est orienté suivant l'épaisseur des couches. Dans la suite de la description, les termes « inférieur » et « supérieur » s'étendent comme étant relatifs à un positionnement croissant lorsqu'on s'éloigne de la couche support 3 suivant la direction +Z.

La source laser 1 comporte un empilement formé d'une couche support 3, d'une couche sacrificielle 4 et d'une couche semiconductrice 10 réalisée en un composé semiconducteur cristallin de préférence monocristallin. La couche support 3 est de préférence en un oxyde de silicium $SiO_x$ (par ex. $SiO_2$) mais peut être réalisée en un matériau choisi parmi le silicium, le saphir, le borosilicate, la silice, le verre, le quartz, ou tout autre matériau adapté. Il est choisi en un matériau présentant un indice de réfraction inférieur à celui du guide d'onde intégré 40. La couche sacrificielle 4 peut être réalisée en un matériau choisi parmi un oxyde ou un nitrure de silicium, entre autres. La couche semiconductrice 10 est réalisée à base de germanium, c'est-à-dire en germanium et/ou en ses alliages. La couche sacrificielle 4 peut présenter une épaisseur de l'ordre de quelques dizaines de nanomètres à quelques microns. La couche support 3 peut présenter une épaisseur de quelques dizaines de nanomètres à quelques centaines de microns.

La couche semiconductrice 10 est formée d'une partie structurée 11 suspendue au-dessus de la couche support 3 et d'une partie périphérique (non représentée) qui entoure la partie structurée 11. La partie périphérique repose sur la couche sacrificielle 4, celle-ci formant une cavité 5 située sous la partie structurée 11. La partie structurée 11 comporte une portion centrale 20 reliée à la partie périphérique par des portions latérales 30 formant des bras tenseurs. La portion centrale 20 peut présenter une forme, dans le plan (X,Y), sensiblement carrée, et de préférence rectangulaire, de quelques centaines de nanomètres à quelques microns de largeur. La couche semiconductrice 10 peut présenter, selon les propriétés optiques voulues du mode optique résonnant, une épaisseur de l'ordre de quelques dizaines de nanomètres à quelques microns, voire davantage. Dans la partie structurée 11, la membrane suspendue présente une face inférieure 11.1 orientée vers la couche support 3 et une face supérieure 11.2 opposée, et des flancs latéraux 11.3 reliant les faces inférieure 11.1 et supérieure 11.2 l'une à l'autre.

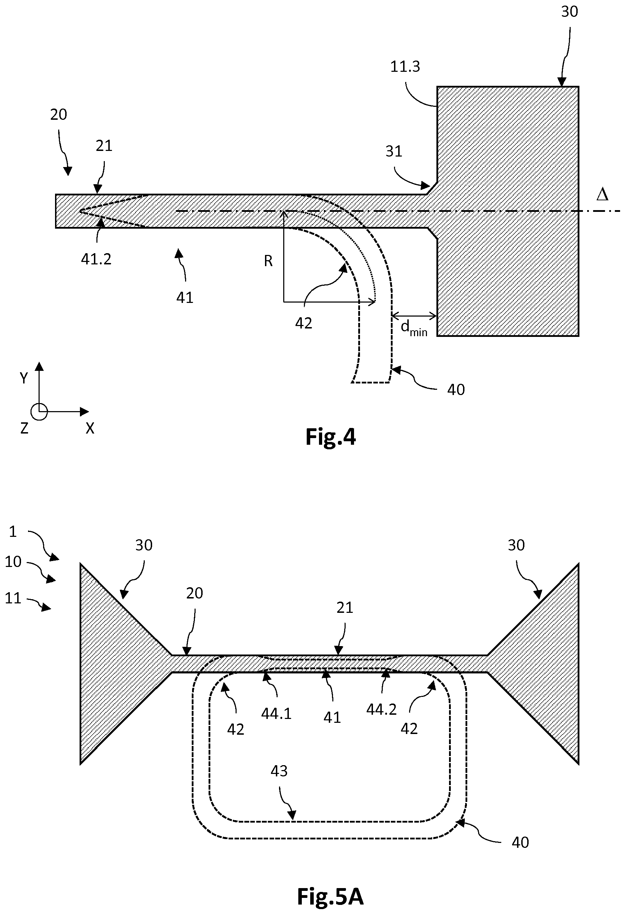

Deux portions latérales 30 sont réalisées qui relient chacune une bordure de la portion centrale 20 à la partie périphérique. Elles sont agencées vis-à-vis de la portion centrale 20 de manière à définir au moins un axe longitudinal de déformation $\Delta$ sensiblement rectiligne. Ainsi, la portion centrale 20 subit une déformation uniaxiale en tension suivant l'axe de déformation $\Delta$, celui-ci coïncidant avec l'axe longitudinal de la portion centrale 20 et avec l'axe longitudinal des portions latérales 30. La dimension surfacique dans le plan XY, et en particulier la largeur de chaque portion latérale 30, est telle que les portions latérales 30 présentent une déformation négligeable par rapport à celle subie par la portion centrale 20. Plus précisément, la déformation locale diminue fortement à mesure qu'on s'éloigne de la portion contrainte 20, de sorte que la déformation moyenne subie par les portions latérales 30 est quasiment négligeable. Les portions latérales 30 présentent ici une forme de rectangle, mais d'autres formes sont possibles, par exemple une forme de trapèze dont la largeur augmente continûment à mesure que l'on s'éloigne de la portion centrale 20 (cf. fig.4A). Les portions latérales 30 peuvent comporter une partie intermédiaire 31, dite jonction, située entre la portion centrale 20 et une partie élargie de grande largeur de la portion latérale (cf. fig.4). Les jonctions 31 présentent une largeur dans le plan XY qui augmente en s'éloignant de la portion centrale 20.

La portion centrale 20 est une portion contrainte en tension, c'est-à-dire qu'elle présente une déformation de son réseau cristallin par augmentation du paramètre de maille naturel. Les portions latérales 30 permettent d'augmenter la valeur initiale de contrainte en tension dans la portion centrale 20, de préférence sans pour autant subir elles-mêmes une contrainte mécanique significative. Elles forment ainsi des bras tenseurs 30. Pour cela, les bras tenseurs 30 et la portion centrale 20 sont dimensionnés pour que la largeur moyenne « b » des bras tenseurs 30 soit supérieure à la largeur moyenne « a » de la portion centrale 20, de préférence dix fois supérieure à cette dernière. Par largeur, on entend la dimension locale entre les flancs latéraux opposés d'une portion ou d'un bras, dans le plan XY. L'épaisseur est la dimension locale entre les faces inférieure et supérieure suivant l'axe Z. La portion centrale 20 présente une dimension longitudinale de longueur, ici orientée suivant l'axe X, qui coïncide avec l'axe Δ de déformation, et des dimensions transversales de largeur suivant l'axe Y et d'épaisseur suivant l'axe Z. De préférence, la portion centrale 20 présente des dimensions transversales de largeur et d'épaisseur constantes sur toute sa longueur, de manière à rendre homogènes les contraintes mécaniques en tension subies par la portion centrale 20. Elle peut néanmoins présenter une largeur variable en regard de transformateurs de mode 41.1, 41.2 (décrits plus loin) pour faciliter le couplage optique local entre le guide d'onde intégré 40 et la portion centrale 20.

La structuration de la membrane suspendue peut avoir été réalisée de manière à contrôler la valeur de l'amplification de la contrainte en tension de la portion centrale 20, obtenue lors de la réalisation de la cavité 5 et donc lors de la suspension de la membrane. Pour cela, on prédétermine les paramètres dimensionnels de la partie structurée 11, par exemple les largeurs et longueurs de la portion centrale 20 et des bras tenseurs 30. A titre d'exemple, dans le cas d'une portion centrale 20 rectangulaire, de longueur L et de largeur moyenne constante a, et des bras tenseurs 30 rectangulaires de longueur B/2-A/2 et de largeur constante b, un facteur d'amplification f reliant la contrainte finale $\sigma^f$ en tension de la portion centrale 20 à la contrainte initiale $\sigma^i$ en tension peut s'exprimer par la relation suivante formulée dans l'article de Süess et al intitulé Analysis of enhanced light emission from highly strained germanium microbridges, Nature Photon. 7, 466-472 (2013) :

$$f = \frac{2L_{ps} + B}{B}\left(1 + \frac{L}{B - L}\right)\bigg/\left(\frac{a}{b} + \frac{L}{B - L}\right)$$

où $L_{ps}$ est la longueur de la partie structurée 11 suspendue. Ainsi, en fonction des paramètres dimensionnels de la partie structurée 11 de la couche semiconductrice 10, on est en mesure de contrôler la valeur de l'amplification de la contrainte en tension appliquée à la portion centrale 20 lors de la réalisation de la cavité 5. Le facteur d'amplification peut également être estimé au moyen d'un logiciel de simulation numérique tel que COMSOL Multiphysics.

Le matériau cristallin à base de germanium de la couche semiconductrice 10 présente, en l'absence de contraintes mécaniques en tension, une structure de bandes d'énergie indirecte. Le matériau à base de germanium situé dans la portion centrale 20 subit alors une contrainte en tension suffisante pour que sa structure de bandes d'énergie soit sensiblement directe. A titre d'exemple, la membrane suspendue est réalisée en germanium et la portion centrale 20 présente une longueur de 15μm environ et des dimensions transversales de largeur et d'épaisseur constantes de 600nm environ. Les bras tenseurs 30 présentent une forme rectangulaire de 55μm environ de largeur pour une épaisseur de 600nm environ. La portion centrale 20 présente alors une déformation homogène en tension, de l'ordre de 5,2% environ. La structure de bandes d'énergie du germanium dans la portion centrale 20 est alors sensiblement directe.

Comme mentionné précédemment, la source laser 1 comporte un milieu à gain 22 à base de germanium, situé dans une section longitudinale 21, dite d'amplification optique, de la portion centrale 20. Le milieu à gain 22 est situé en outre dans la cavité optique résonnante, qui présente une forme longitudinale d'anneau dans le premier mode de réalisation. Cette cavité optique est formée par le guide d'onde intégré 40 en anneau et par la section suspendue d'amplification optique 21 qui est couplée optiquement à l'anneau 40 par onde évanescente.

Le milieu à gain 22 est situé dans une partie longitudinale 21 de la portion centrale 20 en regard de laquelle se trouve une section 41, dite de couplage, du guide d'onde intégré 40. Cette partie est alors appelée section longitudinale 21, ou section suspendue, d'amplification optique. Elle est de préférence située au centre de la portion centrale 20, et ne s'étend sensiblement pas hors de la portion centrale 20. Ainsi, la section d'amplification optique 21 est située dans une portion contrainte dont les contraintes mécaniques en tension sont sensiblement homogènes, et d'une valeur telle que, de préférence, la structure de bandes d'énergie soit sensiblement directe. En variante, la portion contrainte dans laquelle est située la section d'amplification optique 21 peut ne pas présenter une structure de bandes sensiblement directe, mais peut être dopée de type n à un niveau de dopage suffisant pour permettre l'émission du rayonnement lumineux. Le fait que la portion centrale 20 soit davantage contrainte en tension que les bras tenseurs 30, dont les contraintes mécaniques peuvent être négligeables, se traduit par une diminution de l'énergie de bandes interdites de la portion centrale 20 vis-à-vis des bras tenseurs 30, ce qui permet d'assurer un confinement des porteurs de charge injectés dans la portion centrale 20.

Le milieu à gain 22 est adapté à émettre un rayonnement lumineux dont le spectre d'émission présente un pic centré sur la longueur d'onde λ. La longueur d'onde d'émission λ est inversement proportionnelle à l'énergie de bandes interdites Eg du composé semiconducteur qui forme le milieu à gain 22, et peut être sensiblement égale à 1,24/Eg, où Eg est exprimé en électronvolts et dépend de la valeur de la déformation en tension, et où la longueur d'onde λ est exprimée en micromètres. La valeur de l'énergie de bandes interdites peut être estimée en fonction de la déformation en tension, comme le décrit la publication de Guilloy et al intitulée Germanium under high tensile stress: Nonlinear dependence of direct band gap vs strain, ACS Photonics 2016, 3, 1907-1911. A titre d'exemple, la longueur d'onde d'émission λ d'une source laser 1, dont la membrane suspendue est réalisée en germanium contraint en tension de l'ordre de 5,2% environ, peut être supérieure ou égale à 1,6μm, par exemple comprise entre 2μm et 6μm.

La portion centrale 20 de la membrane suspendue est adaptée à supporter le mode optique produit par le milieu à gain 22 et parcourant la cavité optique résonnante. Elle forme ainsi le cœur d'un guide d'onde suspendu 20, entouré par un milieu de bas indice optique (vide, gaz, matériau d'encapsulation...) qui forme la gaine du guide d'onde suspendu 20. A titre d'exemple, la portion centrale 20 peut être dimensionnée pour que le mode optique guidé soit polarisé essentiellement en mode TE (transverse électrique), c'est-à-dire qu'il présente un plan de polarisation sensiblement parallèle au plan du guide. Pour cela, il présente une largeur supérieure à son épaisseur. La portion centrale 20 peut, en variante, être dimensionnée de sorte que son épaisseur soit supérieure à sa largeur, ce qui implique que le signal optique est essentiellement polarisé en mode TM (transverse magnétique). Elle peut supporter à la fois un mode TE et un mode TM lorsque ses dimensions transversales de largeur et d'épaisseur sont du même ordre de grandeur ou sont grands par rapport à la longueur d'onde. Les dimensions transversales de hauteur et de largeur peuvent être de l'ordre de quelques centaines de nanomètres à quelques microns. Sa longueur, c'est-à-dire la longueur de la portion centrale 20 délimitée par les jonctions avec les bras tenseurs 30, peut être de l'ordre de quelques microns à quelques centaines de microns, en fonction du nombre de défauts structuraux éventuellement présents dans la portion centrale 20. De préférence, la longueur est de l'ordre d'une dizaine à quelques dizaines de microns, par exemple est comprise entre 10μm et 50μm, par exemple est égale à 20μm environ.

De préférence, le milieu à gain 22 est une zone intrinsèque de la portion centrale 20, c'est-à-dire non intentionnellement dopée. Il peut être situé entre deux zones dopées 32, 33, qui s'étendent dans les bras tenseurs 30 jusqu'à venir au contact de la zone intrinsèque 21. Ces zones dopées 32, 33, par exemple n et p, sont optionnelles mais permettent d'améliorer l'injection des porteurs de charge jusqu'au milieu à gain 22. Plus précisément, les zones dopées 32, 33 sont situées dans les bras tenseurs 30, de sorte qu'une zone 32 dopée p est située dans un premier bras tenseur 30, et une zone 33 dopée n est située dans un deuxième bras tenseur 30 opposé au premier. Chaque zone dopée 32, 33 peut être localisée uniquement dans un bras tenseur 30, ou peut s'étendre également dans la portion centrale 20 jusqu'au milieu à gain 22. A titre illustratif, le milieu à gain 22 peut être réalisé en germanium intrinsèque présentant une déformation en tension de 5,2% environ. En variante, le milieu à gain 22 peut être dopée de type n. Dans ce cas, la déformation en tension du germanium peut être moindre, par exemple de l'ordre de 3,5% pour un niveau de dopage de l'ordre de $10^{19}$ cm$^{-3}$, permettant ainsi l'émission du rayonnement lumineux. La zone 33, dopée de type n, présente alors un niveau de dopage supérieur à celui du milieu à gain 22.

Par ailleurs, deux plots électriques 6 (cf. fig.3A et 3B) sont prévus pour être au contact des bras tenseurs 30 de part et d'autre de la portion centrale 20, par exemple l'un au contact de la zone 32 dopée p et l'autre de la zone 33 dopée n. Ainsi, la polarisation électrique des bras tenseurs 30, et le cas échéant des zones dopées, permet d'assurer le pompage électrique du milieu à gain 22 et donc l'émission du rayonnement lumineux. Par ailleurs, des couches de bas indice (non représentées) peuvent être disposées de manière à entourer le milieu à gain 22 et ainsi espacer le mode optique vis-à-vis des plots électriques 6, permettant ainsi de limiter les pertes optiques.

Les figures 3A et 3B sont des vues en coupe longitudinale illustrant schématiquement deux exemples de la source laser 1 selon le mode de réalisation.

Selon l'exemple illustré sur la figure 3A, le milieu à gain 22 est formé d'une zone en germanium intrinsèque de la portion centrale 20. Plus précisément, la zone 22 en germanium intrinsèque s'étend sur toute l'épaisseur de la portion centrale 20 et est de préférence positionnée au centre de la portion centrale 20. Les zones 32, 33 dopées p et n peuvent présenter un niveau de dopage respectif de l'ordre de $10^{19}$ cm$^{-3}$, par exemple compris entre $5.10^{18}$ cm$^{-3}$ et $5.10^{19}$ cm$^{-3}$ environ. Elles s'étendent dans le plan XY jusqu'à venir au contact de la zone intrinsèque 22. Dans cet exemple, le milieu à gain 22 est situé au centre de la portion centrale 20 et présente une longueur La inférieure ou égale à la longueur L de la portion centrale 20. Il est donc situé dans une zone où les contraintes mécaniques en tension sont sensiblement homogènes et suffisantes pour que la structure de bandes d'énergie soit ici sensiblement directe. De plus, un confinement de porteurs est assuré par l'énergie de bandes interdites de la portion centrale 20 qui est inférieure à celle des bras tenseurs 30. Les zones 32, 33 dopées p et n s'étendent dans les bras tenseurs 30 jusqu'à venir au contact du milieu à gain 22. Dans cet exemple, les zones dopées 32, 33 s'étendent alors en partie dans la portion centrale 20 jusqu'à la zone intrinsèque 22. Dans ce cas, il est avantageux que le guide d'onde intégré 40 ne soit pas en regard, c'est-à-dire à la perpendiculaire, des zones dopées 32, 33, de manière à ainsi limiter les risques de pertes optiques. La membrane suspendue forme alors une jonction PIN horizontale. La longueur L est la longueur de la portion centrale 20, La est la longueur de la section suspendue d'amplification optique 21 qui comporte la zone intrinsèque 22, et La$_{eff}$ est la longueur effective d'amplification optique, c'est-à-dire la longueur de la section 21 en regard de laquelle se trouve la section de couplage 41 du guide d'onde intégré 40. En variante, le milieu à gain 22 peut ne pas présenter une structure de bandes directe, mais est dopé de type n à un niveau de dopage suffisant pour permettre l'émission lumineuse, par exemple à un niveau de dopage de l'ordre de $1.10^{19}$ cm$^{-3}$. La zone 33 dopée n présente alors un niveau de dopage supérieur à celui du milieu à gain 22, par exemple de l'ordre de $3.10^{19}$ cm$^{-3}$.

Selon l'autre exemple illustré sur la figure 3B, la membrane suspendue comporte une jonction PIN verticale dont les zones dopées 32, 33 et intrinsèque 22 forment un empilement suivant l'axe Z. L'étendue longitudinale de la zone intrinsèque 22 située entre les zones dopées 32, 33 définit la longueur La de la section d'amplification optique 21. La jonction PIN horizontale comporte alors une zone inférieure 32, dopée selon un premier type de conductivité, par exemple de type p, recouverte d'une zone intermédiaire intrinsèque 22 formant le milieu à gain, elle-même recouverte d'une zone supérieure 33 dopée selon un second type de conductivité opposé au premier type, par exemple de type n. La zone inférieure 32 dopée p s'étend dans l'un des bras tenseurs 30 et est au contact d'un premier plot de polarisation 6. La zone supérieure 33 dopée n s'étend dans l'autre bras tenseur 30 et est au contact d'un second plot de polarisation 6. La zone intrinsèque 22 peut en outre comporter au moins un puits quantique situé entre deux couches barrières de plus grande énergie de bandes interdites. A titre illustratif, le ou les puits quantiques peuvent être réalisés entre GeSn et les couches barrières en SiGeSn. Les parties dopées inférieure 32 et supérieure 33 peuvent être réalisées en Ge. Dans cet exemple, le milieu à gain 22 présente une longueur La égale à la longueur L de la portion centrale 20. Les zones dopées 32, 33 s'étendent alors également dans la portion centrale 20. Comme mentionné précédemment, le milieu à gain 22 peut ne pas présenter une structure de bandes directe, mais est dopé de type n à un niveau de dopage suffisant pour permettre l'émission lumineuse. La zone 33 dopée n présente alors un niveau de dopage supérieur à celui du milieu à gain 22.

La source laser 1 comporte donc une cavité optique résonnante. Dans le premier mode de réalisation, la cavité optique présente une forme longitudinale d'anneau. Elle est formée au moins en partie par le guide d'onde intégré 40 en anneau auquel est couplée optiquement la section suspendue d'amplification optique 21 de la portion centrale 20. Cette section d'amplification optique 21 participe également à former la cavité optique avec le guide d'onde intégré 40.

Le guide d'onde intégré 40 est un guide d'onde disposé ici dans la couche support 3, dans le sens où au moins ses faces latérales et sa face inférieure sont entourées par le matériau de la couche support 3. Il peut affleurer la face supérieure de la couche support 3, ou être recouvert par celle-ci. Le guide d'onde intégré 40 est réalisé en un matériau de haut indice de réfraction, et est entouré par un milieu de bas indice de réfraction formant la gaine du guide. Cette gaine est formée par le matériau de la couche support 3 qui entoure le cœur, ainsi que par celui séparant le cœur de la portion centrale 20. A titre d'exemple, le guide d'onde intégré 40 et la couche support 3 peuvent être réalisés à base de silicium. Par exemple, le guide d'onde intégré 40 peut être en silicium, et la couche support 3 est en oxyde de silicium SiO$_2$. Le guide d'onde intégré 40 peut présenter des dimensions transversales de largeur et d'épaisseur telles que le mode optique guidé présente le même type de polarisation TE et/ou TM que le mode guidé dans la section suspendue d'amplification optique 21.

Le guide d'onde intégré 40 s'étend longitudinalement de manière à former un anneau, c'est-à-dire une boucle. Comme mentionné plus loin, la boucle peut être continue ou discontinue. D'une manière générale, il présente une étendue longitudinale dans le plan XY en forme de cercle, d'ovale, de rectangle à coins arrondis, ou peut présenter des formes plus complexes, notamment pour intégrer des fonctions optiques additionnelles (filtrage, modulation...).

La figure 4 est une vue de dessus d'une partie de la source laser 1 selon le mode de réalisation, au niveau de la jonction 31 d'un bras tenseur 30 avec la portion centrale 20. Comme l'illustre la fig.2A et plus précisément la fig.4, le guide d'onde intégré 40 comporte trois sections principales, à savoir une section de couplage 41, ici deux sections courbes 42 situées aux extrémités longitudinales de la section de couplage 41, et une section dite distale 43, c'est-à-dire distante vis-à-vis de la section de couplage 41, reliée à cette dernière par les deux sections courbes 42.

La section de couplage 41 est agencée de manière à permettre un couplage optique avec la section suspendue d'amplification optique 21 par onde évanescente. Plus précisément, la section de couplage 41 est située en regard, c'est-à-dire à la perpendiculaire suivant l'axe Z, et à distance de la section suspendue d'amplification optique 21. Elles sont donc au moins en partie superposées l'une à l'autre suivant l'axe Z. La section de couplage 41 peut être continue ou discontinue. Elle peut présenter une variation locale de ses dimensions transversales, c'est-à-dire une variation de sa largeur locale et/ou de son épaisseur locale suivant son axe longitudinal, pour que l'indice effectif du mode optique supporté par la section de couplage 41 passe localement d'une valeur supérieure à l'indice effectif du mode optique supporté par la section suspendue d'amplification optique 21, à une valeur inférieure à celui-ci, notamment lorsqu'elle comporte des transformateurs de mode 41.1, 41.2.

D'une manière générale, l'indice effectif $n_{eff}$ associé à un mode optique supporté par un guide d'onde est défini comme le produit de la constante de propagation $\beta$ et de $\lambda/2\pi$. La constante de propagation $\beta$ dépend de la longueur d'onde $\lambda$ du mode optique, ainsi que des propriétés du guide d'onde (indice de réfraction et dimensions transversales). L'indice effectif du mode optique correspond, d'une certaine manière, à l'indice de réfraction du guide d'onde 'vu' par le mode optique. Il est habituellement compris entre l'indice du cœur et l'indice de la gaine du guide d'onde.

L'espacement e (cf. fig.2B) entre la section de couplage 41 du guide d'onde intégré 40 et le guide d'onde suspendu 20 est non nul et peut être compris entre quelques nanomètres et quelques centaines de nanomètres, par exemple est compris entre 10nm et 500nm. Cet espacement est défini comme la distance suivant l'axe Z entre la face supérieure du guide d'onde intégré 40 et la face inférieure 11.1 du guide d'onde suspendu 20. Il est choisi de manière à permettre le couplage modal entre le guide d'onde intégré 40 et la section suspendue d'amplification optique 21.

Le couplage optique s'étend comme une distribution locale de l'énergie du mode optique résonnant au niveau du guide d'onde intégré 40 et de la section suspendue d'amplification optique 21. Ainsi, localement, le mode optique résonnant s'étale à la fois sur le guide d'onde intégré 40 et le guide d'onde suspendu, formant ainsi localement un supermode. Le couplage optique local s'exprime par l'accord de phase entre le mode optique supporté par le guide d'onde intégré 40 et celui supporté par le guide d'onde suspendu 20, c'est-à-dire par la quasi-égalité voire l'égalité entre les constantes de propagation $\beta$ des modes optiques supportés par les deux guides d'onde 20, 40, se traduisant par la quasi-égalité voire l'égalité des indices effectifs $n_{eff}$ des modes optiques supportés par ces guides d'onde 20, 40.

De préférence, comme l'illustrent les fig.2A et 3A, la section de couplage 41 du guide d'onde intégré 40 est discontinue et comporte deux transformateurs de mode 41.1, 41.2, situées en regard de la section suspendue d'amplification optique 21. Un transformateur de mode 41.1, 41.2 est défini comme une zone en pointe du guide d'onde intégré 40, c'est-à-dire une zone dont la largeur et/ou l'épaisseur varient suivant son axe longitudinal jusqu'à s'annuler. Cette variation longitudinale d'au moins une dimension transversale, ici la largeur, se traduit par une variation de l'indice effectif du mode optique guidé, permettant à celui-ci d'être transmis, aux pertes près, d'un guide d'onde à l'autre. Les transformateurs de mode 41.1, 41.2 peuvent être dimensionnés pour permettre une transmission adiabatique et totale du mode optique entre les guides d'onde 20, 40, comme le décrit la publication de Sun et al. intitulée Adiabaticity criterion and the shortest adiabatic mode transformer in a coupled-waveguide system, Opt. Lett., 34, 280 (2009). Plus précisément, le caractère adiabatique d'un transformateur de mode peut s'exprimer par une variation longitudinale adéquate d'au moins une dimension transversale, par exemple sa largeur. Dans un tel cas, le taux de couplage dépend de la longueur du transformateur de mode. Le transfert du mode optique est total lorsque sa longueur est suffisante.

Ainsi, la section de couplage 41 du guide d'onde intégré 40 comporte un premier transformateur de mode 41.1 dont la largeur diminue continûment jusqu'à zéro suivant la direction +X permettant au mode optique se propageant dans cette direction d'être transmis, de préférence de manière adiabatique et totale, du guide d'onde intégré 40 à la section suspendue d'amplification optique 21. Elle comporte un second transformateur de mode 41.2, situé dans le prolongement longitudinal du guide d'onde intégré 40, dont la largeur augmente continûment à partir de zéro suivant la direction +X, permettant ainsi au mode optique se propageant dans la section suspendue d'amplification optique 21 d'être transmis, de préférence de manière adiabatique et totale, dans le guide d'onde intégré 40. Un mode guidé circulant dans le sens contraire subira la même transmission optique entre les deux guides d'onde 20, 40.

Ainsi, le mode optique peut parcourir la section suspendue 21 assurant la fonction d'amplification optique, ainsi que le guide d'onde intégré 40 en anneau assurant la fonction de résonateur optique. Les transformateurs de mode 41.1, 41.2 sont de préférence adiabatiques, et peuvent présenter un couplage total ou partiel selon que l'extraction lumineuse, c'est-à-dire l'émission du mode guide hors de la cavité optique, a lieu par la membrane suspendue ou par le guide d'onde intégré 40. Dans cet exemple où l'extraction lumineuse a lieu dans la membrane suspendue, au moins l'un des transformateurs de mode 41.1, 41.2 n'est pas adiabatique ou présente un couplage qui n'est pas total. Ainsi, le mode optique n'est pas totalement transféré, permettant ainsi une extraction lumineuse par la membrane suspendue. Par couplage optique total et partiel, on entend un taux de couplage respectivement supérieur et inférieur à 80%.

Le guide d'onde intégré 40 comporte en outre deux sections courbes 42, formant des coudes situés aux extrémités longitudinales de la section de couplage 41. Ces sections courbes 42 présentent une étendue longitudinale et un rayon de courbure moyen R tels que le guide d'onde intégré 40 ne s'étend pas sous les bras tenseurs 30, évitant ainsi une fuite du mode optique guidé dans les bras tenseurs 30. Le rayon de courbure moyen R est défini à partir d'une ligne longitudinale (trait pointillé) parcourant les barycentres transversaux du guide d'onde intégré 40. Par barycentre transversal, on entend le barycentre associé localement à une section droite transversale du guide d'onde. Ainsi, le guide d'onde intégré 40 est situé à distance des bras tenseurs 30, en projection orthogonale, c'est-à-dire en projection suivant l'axe Z dans un plan principal parallèle au plan XY suivant lequel il s'étend. Il n'y a donc pas de recouvrement, même partiel, entre le guide d'onde intégré 40 et les bras tenseurs 30. Ainsi, la distance minimale $d_{min}$ entre un flanc 11.3 d'un bras tenseur 30 et une face latérale du guide d'onde intégré 40 est supérieure ou égale à zéro. De préférence, elle est supérieure ou égale à $\lambda/4$, minimisant ainsi les risques de fuite du mode optique guidé dans les bras tenseurs 30.

De préférence, le rayon de courbure moyen R est supérieur ou égal à $\lambda/4$, permettant ainsi de limiter les pertes optiques dans les sections courbes 42. A titre d'exemple, un rayon de courbure moyen R sensiblement égal à λ/4 permet de limiter les pertes optiques à au plus 0,05dB environ par virage, celui-ci étant défini comme un quart de cercle. A titre d'exemple, pour une longueur d'onde λ de 2,5μm environ, un rayon de courbure R de l'ordre de 1μm permet de limiter les pertes optiques à 0,017 dB environ par virage, et un rayon de courbure R de l'ordre de 2μm permet de réduire les pertes optiques à $1,6.10^{-4}$ dB environ par virage.

De préférence, le rayon de courbure moyen R est inférieur ou égal à 2λ. Ainsi, la longueur effective $La_{eff}$ d'amplification optique est optimisée, tout en limitant les pertes optiques associées. Ainsi, les pertes optiques associées à un virage de la section courbe 42 peuvent être négligeables, par exemple, être inférieures à $10^{-7}$dB environ par virage lorsque le rayon de courbure R est égal à 3μm environ pour une longueur d'onde λ de 2,5μm). La longueur $La_{eff}$ est la longueur de la section suspendue d'amplification optique 21 parcourue par le mode optique. Elle est inférieure ou égale à la longueur La de la section suspendue d'amplification optique 21, et dépend de l'éloignement relatif entre les deux sections courbes 42 (cf. fig.2B, 3A et 3B) et donc, le cas échéant, entre les transformateurs de mode 41.1,41.2. Un faible rayon de courbure moyen R permet ainsi d'éloigner les sections courbes 42 l'une de l'autre, et donc les transformateurs de mode 41.1, 41.2 l'un de l'autre, optimisant ainsi la longueur effective $La_{eff}$ d'amplification optique. Le gain modal est donc optimisé et les pertes optiques associées aux sections courbes 42 sont limitées.

Le guide d'onde intégré 40 comporte une section distale 43 reliée à la section de couplage 41 par l'intermédiaire des deux sections courbes 42. La section distale 43 peut s'étendre longitudinalement de manière quelconque, et peut intégrer des fonctions optiques additionnelles de filtrage et/ou de modulation optique. De par le dimensionnement des sections courbes 42, le guide d'onde intégré 40 présente, tant au niveau des sections courbes 42 que de la section distale 43, une distance minimale $d_{min}$ supérieure ou égale à zéro, en projection orthogonale, vis-à-vis des bras tenseurs 30, limitant ainsi les risques de fuite dans les bras tenseurs du mode optique circulant dans le guide d'onde intégré 40.

Le cœur du guide d'onde intégré 40 est réalisé dans un matériau de haut indice. Il est choisi de sorte que son indice de réfraction est proche de celui du matériau à base de germanium formant la portion centrale 20, de manière à autoriser le couplage modal entre les deux guides d'onde. Il est de préférence à base de silicium, tel que le silicium, le nitrure de silicium SiN (par ex. $Si_3N_4$), ou peut être à base d'un composé III-V. La gaine du guide d'onde intégré 40 est formée par un milieu de bas indice environnant le matériau de haut indice, par exemple par un oxyde de silicium $SiO_x$ (par ex. $SiO_2$) de la couche support 3 et par le milieu séparant le guide d'onde intégré 40 du guide d'onde suspendu. Il présente des dimensions transversales en largeur et/ou en épaisseur au niveau de sa section de couplage 41, choisies de manière à permettre le couplage modal avec le guide suspendu 20.

En fonctionnement, l'application d'une différence de potentiel aux plots de polarisation 6 entraîne l'injection de porteurs de charge dans les bras tenseurs 30 puis dans la section d'amplification optique 21 de la portion centrale 20. Du fait de la présence d'un puits de potentiel formé par la contrainte en tension subie par la portion centrale 20, les porteurs de charge y restent confinés jusqu'à se recombiner de manière radiative. Cette même contrainte en tension permet à la section d'amplification optique 21 de présenter une structure de bandes d'énergie sensiblement directe, améliorant ainsi le taux de recombinaison radiative. Le mode optique généré parcourt alors la cavité optique en anneau de manière résonnante, par couplage optique par onde évanescente entre la section suspendue d'amplification optique 21 et la section de couplage 41 du guide d'onde intégré 40. L'extraction lumineuse du mode optique généré a lieu dans cet exemple au niveau de la membrane suspendue par le fait que le taux de couplage d'un transformateur de mode n'est pas total.

Ainsi, la cavité optique résonnante est formée par le guide d'onde intégré 40 en anneau, et non pas par de réflecteurs optiques du type miroirs de Bragg situés dans les bras tenseurs 30 comme dans l'exemple de l'art antérieur mentionné précédemment. Les inventeurs ont en effet constaté que la présence de réflecteurs optiques dans les bras tenseurs 30 entraîne la formation de zones de concentration de contraintes à proximité des réflecteurs optiques, et plus précisément au niveau des bordures latérales de ces derniers. Ces zones de concentrations des contraintes mécaniques dans la membrane suspendue, liées à la présence de réflecteurs optiques réalisés dans les bras tenseurs 30, entraînent une dégradation des propriétés mécaniques des bras tenseurs 30 et en conséquence de la membrane suspendue. Cela peut également entraîner une dégradation des propriétés optiques et/ou électroniques de la membrane suspendue et donc de la source laser 1.

Au contraire, la source laser 1 selon le mode de réalisation, par le fait que la cavité optique résonnante est réalisée par le guide d'onde intégré 40 en anneau et que les bras tenseurs 30 ne comportent donc pas de réflecteurs optiques, présente une membrane suspendue dont les propriétés mécaniques sont améliorées par rapport à l'exemple de l'art antérieur, écartant ainsi les risques de dégradation de ses propriétés optiques et/ou électroniques.

Par ailleurs, le fait que le guide d'onde intégré 40 en anneau ne s'étende pas en regard des bras tenseurs 30, du fait de l'agencement des sections courbes 42, permet de limiter les risques de pertes optiques par fuite du mode guidé dans les bras tenseurs 30, ce qui permet d'améliorer le rendement de la source laser 1.

Les figures 5A à 5C sont des vues de dessus, schématiques et partielles, de sources laser 1 suivant différentes variantes du mode de réalisation. Les différentes caractéristiques de ces modes de réalisation peuvent être combinées entre elles.

En référence à la fig.5A, la source laser 1 selon cette variante se distingue de celle illustrée sur la fig.2A essentiellement en ce que la section de couplage 41 du guide d'onde intégré 40 est continue et non plus discontinue. Elle peut présenter des dimensions transversales constantes suivant son axe longitudinal, mais comporte avantageusement deux zones de couplage 44.1, 44.2 qui présentent une variation locale d'une dimension transversale, ici la largeur, de sorte que l'indice effectif associé au mode optique parcourant la section de couplage 41 est inférieur à l'indice effectif associé au mode optique parcourant la section suspendue d'amplification optique 21. Ces zones de couplage augmentent le taux de couplage entre les guides d'onde 20, 40 et permettent au supermode de s'étaler davantage dans la section suspendue d'amplification optique 21. Dans cet exemple, les bras tenseurs 30 présentent une forme trapézoïdale dont la largeur augmente en s'éloignant de la portion centrale 20, limitant ainsi les concentrations de contraintes mécaniques à la jonction entre les bras tenseurs 30 et la portion centrale 20.

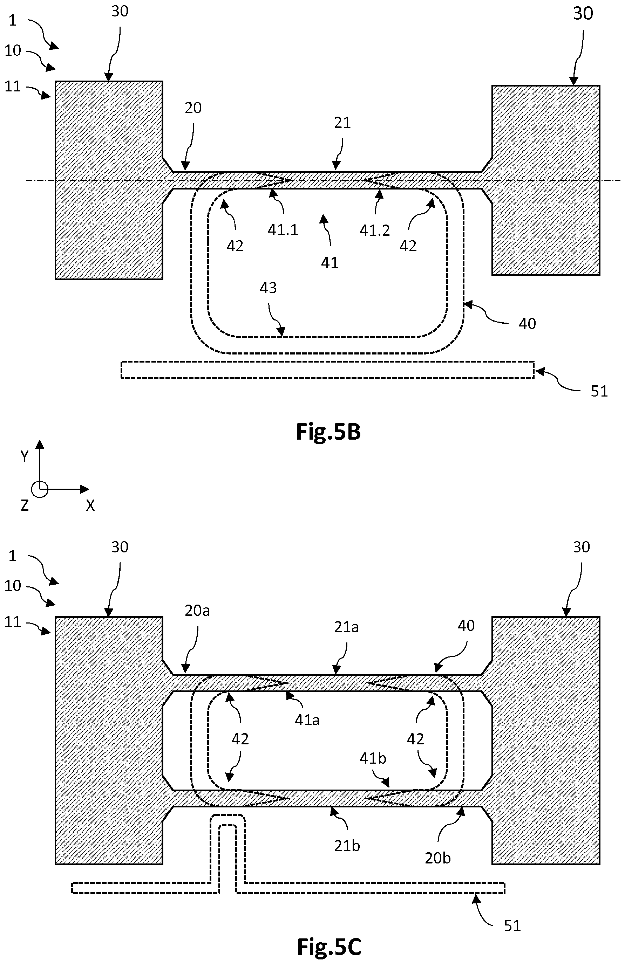

En référence à la fig.5B, la source laser 1 selon cette variante se distingue de celle illustrée sur la fig.2A essentiellement en ce qu'elle comporte un guide d'onde supplémentaire 51 permettant l'extraction lumineuse du mode optique. Dans cet exemple, les transformateurs de mode 41.1, 41.2 sont avantageusement adiabatiques et à couplage total, de manière à éviter l'extraction lumineuse d'une partie du mode optique hors de la section suspendue d'amplification 21 directement dans les bras tenseurs 30. Le gain modal est alors maximisé. Par ailleurs, le guide d'onde d'extraction 51 présente un couplage optique partiel avec la section distale 43 du guide d'onde intégré 40, pour extraire une partie du mode optique guidé. Le taux de couplage optique peut être défini comme la corrélation entre les indices effectifs des modes guidés supportés par le guide d'onde intégré 40 et le guide d'onde d'extraction, et la distance séparant les deux guides d'onde. Dans cet exemple, l'extraction lumineuse dans le guide d'onde d'extraction 51 est bidirectionnelle, dans le sens où une partie du rayonnement lumineux extrait parcourt le guide d'onde 51 dans une direction et une autre partie parcourt le guide d'onde 51 dans la direction opposée. L'extraction lumineuse peut être unidirectionnelle lorsque le guide d'onde d'extraction 51 comporte un réflecteur optique, par exemple un miroir de Bragg, disposé en une de ses extrémités.

En référence à la fig.5C, la source laser 1 selon cette variante se distingue de celle illustrée sur la fig.2A essentiellement en ce que la membrane suspendue comporte au moins deux portions centrales 20a, 20b, parallèles l'une de l'autre, étirées et suspendues par les mêmes bras tenseurs 30. La cavité optique est formée ici par les deux portions du guide d'onde intégré 40 et par les deux sections d'amplification optique 21a, 21b. Le guide d'onde intégré 40 comporte une première section de couplage 41a, ici discontinue, située sous la section d'amplification optique 21a d'une première portion centrale 20a, et une deuxième section de couplage 41b, ici également discontinue, située sous la section d'amplification optique 21b de la deuxième portion centrale 20b. Les sections courbes 42 sont dimensionnées de sorte que le guide d'onde intégré 40 ne soit pas en regard des bras tenseurs 30. Dans cet exemple, l'extraction lumineuse est effectuée par l'intermédiaire d'un guide d'onde supplémentaire 51 dont une section est couplée optiquement au guide d'onde intégré 40. Les transformateurs de mode des deux sections de couplage 41a, 41b sont ici adiabatiques et à couplage total, optimisant alors le gain modal tout en permettant l'extraction lumineuse par le guide 51. En variante, l'extraction lumineuse peut avoir lieu dans la membrane suspendue, à partir de l'une et/ou l'autre des portions centrales 20a, 20b. Pour cela, comme décrit précédemment, au moins l'un des transformateurs de mode des sections de couplage 41a, 41b est non adiabatique et/ou à couplage partiel.

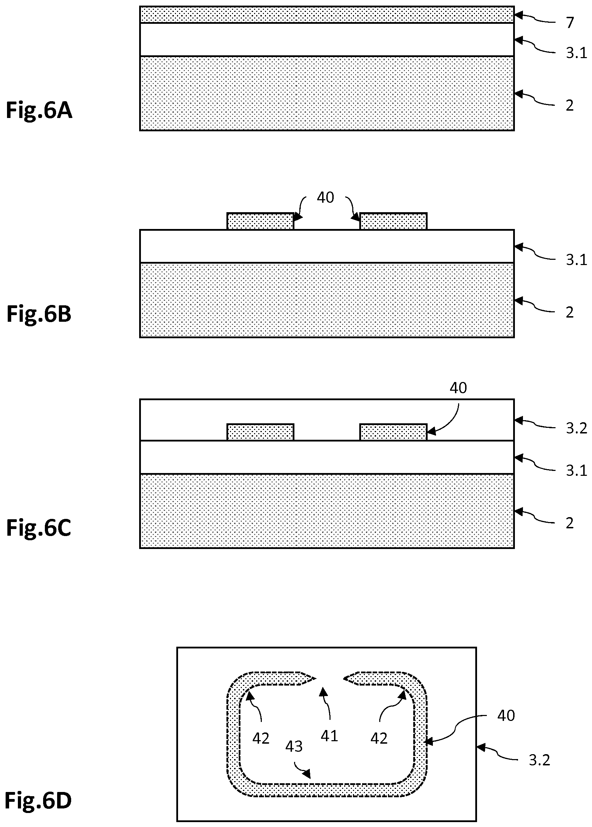

Un exemple de procédé de réalisation d'une source laser 1 selon le mode de réalisation illustré sur la figure 2A est maintenant décrit, en référence aux figures 6A à 6I. Dans cet exemple, la membrane suspendue est réalisée en germanium et le guide d'onde intégré 40 est réalisé en silicium dans une couche support 3 en oxyde de silicium.

On fournit tout d'abord (cf. fig.6A) un empilement de type SOI (*Silicon On Insulator*) formé d'un substrat 2 réalisé par exemple en silicium, d'une couche intermédiaire 3.1 réalisée en oxyde de silicium destinée à participer à la formation de la couche support 3, et d'une couche supérieure 7 en silicium destinée à former le guide d'onde intégré 40.

On forme ensuite (cf. fig.6B) le guide d'onde intégré 40 par gravure localisée de la couche supérieure 7. Le guide d'onde 40 comporte ici une section de couplage 41 discontinue à transformateurs de mode, des sections courbes 42 situées de part et d'autre de la section de couplage 41, et une section distale 43 reliée à la section de couplage 41 par les sections courbes 42 (cf. fig.6D).

On dépose ensuite (cf. fig.6C) une couche d'encapsulation 3.2 qui recouvre les flancs du guide d'onde intégré 40. Cette couche d'encapsulation 3.2 forme, avec la couche intermédiaire 3.1, la couche support 3 dans laquelle est situé le guide d'onde intégré 40. La couche d'encapsulation 3.2 et la couche intermédiaire 3.1 sont réalisées dans un matériau présentant le même indice de réfraction, et de préférence sont réalisées dans le même matériau, ici en SiO$_2$. Dans cet exemple, la face supérieure du guide d'onde intégré 40 est recouverte par la couche d'encapsulation 3.2.

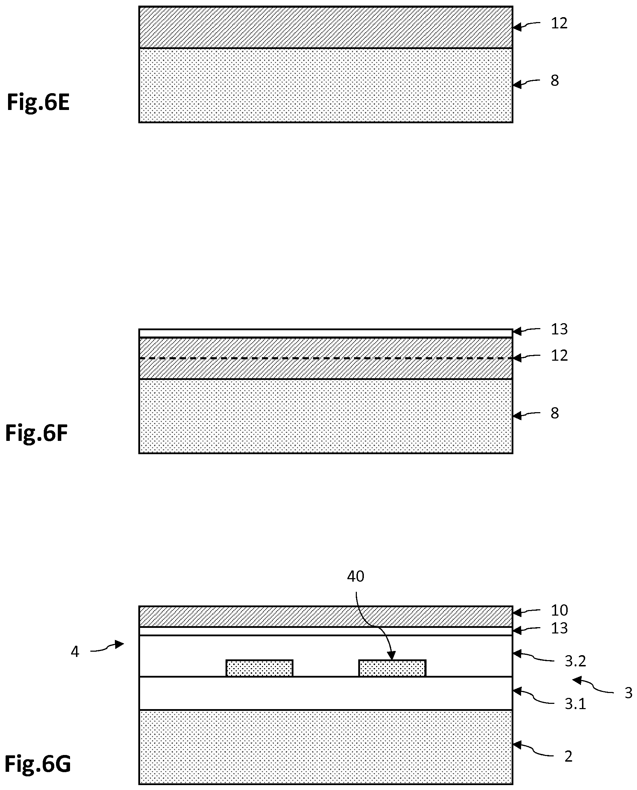

On réalise (fig.6E) une couche épaisse de germanium 12 destinée à former la couche semiconductrice 10. Cette couche épaisse 12 est réalisée par épitaxie à partir d'une couche de germination 8. Elle est dite épaisse dans le sens où son épaisseur est supérieure à l'épaisseur critique à partir de laquelle une libération des contraintes mécaniques associées à l'épitaxie par relaxation plastique a lieu. La couche épaisse 12 présente néanmoins une contrainte mécanique initiale en tension à l'issue de cette étape de réalisation. Cette étape est similaire à celle décrite dans la demande de brevet EP3151265.

On recouvre ensuite (fig.6F) la couche épaisse 12 de germanium d'une couche d'oxyde 13 puis on implante des ions H+ dans la couche de germanium (trait pointillé). La zone d'implantation est localisée dans la partie haute de la couche épaisse où la couche présente moins de défauts structuraux du type dislocations.

On solidarise ensuite (fig.6G) les deux empilements par les couches d'oxyde 13, 3.2. Plus précisément, la couche d'oxyde 13 recouvrant la couche épaisse 12 de germanium est solidarisée à la couche d'encapsulation 3.2 recouvrant le guide d'onde intégré 40. On effectue la rupture de la couche épaisse 12 de germanium au niveau de la zone fragilisée par l'implantation des ions $H^+$, puis polissage mécanique et chimique (CMP) de la couche à base de Ge et on obtient un empilement formé de la couche semiconductrice 10 en germanium, recouvrant une couche sacrificielle 4 en oxyde de silicium qui encapsule le guide d'onde intégré 40.

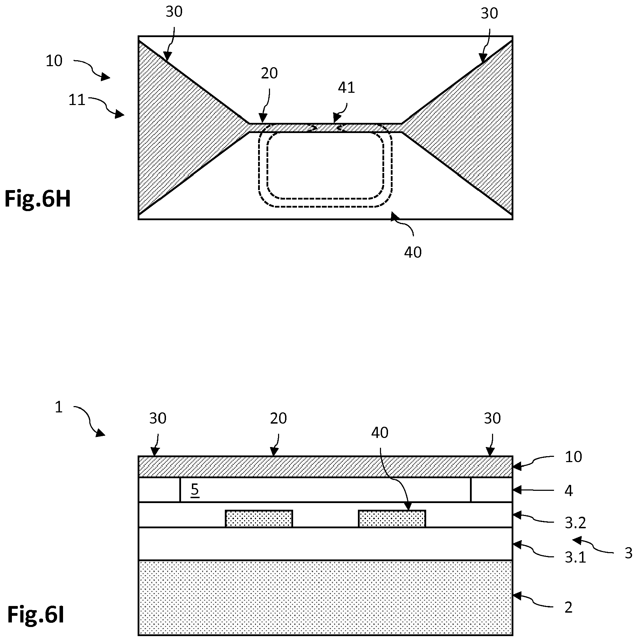

On définit ensuite (fig.6H) la partie structurée 11 et la partie périphérique (non représentée) par gravure localisée de la couche semiconductrice 10. La partie structurée 11 comporte une portion centrale 20 et des portions latérales 30 qui relient celle-ci à la partie périphérique. La portion centrale 20 est située en regard de la section de couplage 41 du guide d'onde intégré 40, et les portions latérales 30 sont situées à distance du guide d'onde intégré. Ce positionnement de la portion centrale 20 vis-à-vis de la section de couplage 41 du guide d'onde intégré 40 peut être obtenu à l'aide de marques d'alignement (non représentés). Des plots de polarisation (non représentés) sont ensuite réalisés sur les portions latérales 30.

On réalise ensuite (fig.6I) la suspension de la membrane par formation de la cavité sous la portion centrale 20 et les bras tenseurs 30. La formation de la cavité peut être obtenue par gravure humide de la partie de la couche sacrificielle 4 (couche d'encapsulation) située sous la portion centrale 20 et les bras tenseurs 30. La gravure humide peut être contrôlée au temps ou par une couche mince d'arrêt de gravure pour qu'une partie du guide d'onde intégré 40 soit encapsulé entièrement par, ou affleure, la couche support 3. La suspension de la membrane entraîne une augmentation contrôlée de la contrainte initiale en tension subie par la couche semiconductrice 10, de sorte que la portion centrale 20 présente une contrainte finale en tension telle que le germanium y présente une structure de bandes d'énergie sensiblement directe. La déformation en tension subie par la portion centrale 20 étant supérieure à celle subie éventuellement par les bras tenseurs 30, l'énergie de bandes interdites du germanium est diminuée dans la portion centrale 20 vis-à-vis des bras tenseurs 30, se traduisant par la formation d'un puits de potentiel permettant le confinement des porteurs de charge injectés. Une couche d'oxyde, par exemple du $SiO_2$, peut ensuite être déposée de manière conforme autour de la portion centrale en germanium pour en améliorer la tenue mécanique. L'effondrement de la portion centrale sur la couche d'oxyde qui recouvre le guide d'onde intégré 40 est également possible.

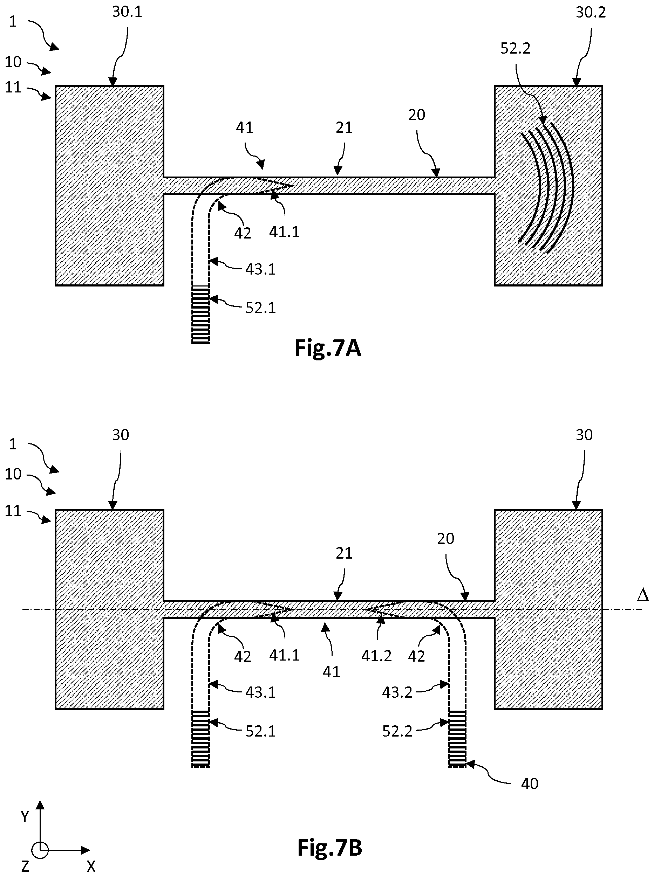

Les figures 7A et 7B sont des vues de dessus, partielles et schématiques de deux variantes de la source laser 1 selon un deuxième mode de réalisation, dans lequel la source laser est de type DBR (pour *Distributed Bragg Reflector,* en anglais).

La figure 7A illustre une première variante dans laquelle la source laser 1 comporte une couche semiconductrice 10 identique ou similaire à celle décrite en référence au premier mode de réalisation, à ceci près qu'un bras tenseur, ici le bras tenseur 30.2, comporte un réflecteur optique 52.2 tel qu'un miroir de Bragg. Ainsi, la source laser 1 selon cette variante se distingue de celle du premier mode de réalisation essentiellement en ce que le guide d'onde intégré 40, qui participe à former la cavité optique, ne présente plus une forme d'anneau mais au contraire une forme longitudinale dite ouverte, c'est-à-dire que la section distale 43.1 est reliée qu'à une extrémité de la section de couplage 41 et non pas aux deux extrémités. Ici, la cavité optique est définie par deux réflecteurs optiques 52.1, 52.2, ici des miroirs de Bragg. Dans cet exemple, un premier miroir de Bragg 52.1 est situé dans la section distale 43.1 du guide d'onde intégré 40 et un deuxième miroir de Bragg 52.2 est positionné dans le bras tenseur 30.2.

Plus précisément, dans cet exemple, le bras tenseur 30.1 ne comporte pas de miroir de Bragg, et le bras tenseur 30.2 comporte un miroir de Bragg 52.2 identique ou similaire à celui décrit en référence à la fig.1. De plus, le guide d'onde intégré 40 comporte une section de couplage 41, une section distale 43.1, et une section courbe 42 assurant la jonction entre la section de couplage 41 et la section distale 43.1. La section de couplage 41 est ici formée d'un transformateur de mode 41.1, de préférence adiabatique. Le couplage optique peut n'être pas total, de manière à permettre une extraction lumineuse par la membrane suspendue. Il peut en variante être total, pour permettre une extraction lumineuse par l'intermédiaire d'un guide d'onde d'extraction (non représenté) situé dans la couche support.

Le guide d'onde intégré 40 ne comporte ici qu'une seule section courbe 42 dans la mesure où la section distale 43.1 ne referme pas le guide d'onde intégré 40 sur lui-même, contrairement au guide d'onde intégré 40 en anneau. La section distale 43.1 comporte un réflecteur optique 52.1, ici un miroir de Bragg. La section courbe 42 est agencée de sorte que le guide d'onde intégré 40 ne s'étende pas sous les bras tenseurs 30, en particulier sous le bras tenseur 30.1. Plus précisément, elle est agencée de sorte que le guide d'onde intégré 40 soit à distance, en projection orthogonale, des bras tenseurs 30. Ainsi, on évite que le mode optique ne fuie dans les bras tenseurs.

Ainsi, la source laser 1 est de type DBR dont la section d'amplification optique 21 est située dans la membrane suspendue à base de germanium, et dont la cavité optique est hybride et définie par les réflecteurs optiques 52.1 et 52.2. Le mode optique parcourt ainsi la section d'amplification optique 21 de la membrane suspendue ainsi que le guide d'onde intégré 40, et est réfléchi par le miroir de Bragg 52.1 situé dans la section distale 43.1 du guide d'onde intégré 40, et par le miroir de Bragg 52.2 situé dans le bras tenseur 30.2.

Dans la mesure où le bras tenseur 30.1 ne comporte pas de miroir de Bragg, les propriétés mécaniques de la membrane suspendue, et en particulier celles du bras tenseur 30.1, sont améliorées par rapport à l'exemple de l'art antérieur cité précédemment, et donc également les propriétés électriques et/ou optiques de la membrane suspendue. La source laser 1, ici de type DBR, présente ainsi des propriétés électriques et/ou optiques améliorées.

Ce mode de réalisation est particulièrement avantageux lorsqu'au moins un miroir de Bragg est situé dans le guide d'onde intégré 40. En effet, un miroir de Bragg est habituellement formé d'une pluralité de gravures locales périodiques du guide d'onde intégré 40. Pour obtenir une réflectivité élevée du miroir de Bragg sur une gamme étroite de longueurs d'onde, contribuant ainsi à rendre monochromatique la cavité optique, un miroir de Bragg peut comporter plusieurs dizaines voire centaines de périodes, et présenter ainsi une longueur de l'ordre de plusieurs dizaines voire centaines de microns, par exemple une longueur supérieure à 50$\mu$m environ. Or, à titre illustratif, la portion centrale 20 peut présenter une longueur égale à 20$\mu$m environ, pour laquelle elle présente une bonne tenue mécanique contenue du nombre d'éventuels défauts structuraux qu'elle peut comporter. De plus, la section de couplage 41 peut présenter une longueur de l'ordre de quelques microns à dizaines de microns, par exemple 10$\mu$m, et la section courbe peut présenter un rayon de courbure de l'ordre de quelques microns, par exemple 3$\mu$m. Aussi, le fait de disposer le miroir de Bragg 52.1 dans la section distale 43.1, et donc à distance des bras tenseurs 30 de par la section courbe 42, permet de limiter les pertes optiques par fuite du mode optique dans les bras tenseurs 30, tout en optimisant le gain modal par la longueur importante de la section d'amplification optique 21, et en bénéficiant de miroirs de Bragg à haute réflectivité et sélectivité en longueur d'onde. De plus, par le rayon de courbure de la section courbe 42 avantageusement compris entre $\lambda$/4 et 2$\lambda$, on maximise la longueur d'amplification optique et donc le gain modal, tout en limitant encore les pertes optiques.

La figure 7B illustre une deuxième variante dans laquelle la source laser 1 se distingue de celle illustrée sur la fig.7A essentiellement en ce que la cavité optique est définie par deux réflecteurs optiques, ici des miroirs de Bragg 52.1, 52.2 disposés chacun dans des sections distales 43.1, 43.2 distinctes l'une de l'autre du guide d'onde intégré 40.

Ainsi, les bras tenseurs 30 de la membrane suspendue ne comportent pas de réflecteur optique. Les propriétés mécaniques de la membrane suspendue sont alors améliorées par rapport à celles de l'exemple de l'art antérieur mentionné précédemment et par rapport à celles de la variante illustrée sur la fig.7A. La membrane suspendue, et donc la source laser, présente alors des propriétés électriques et/ou optiques améliorées, comme mentionné précédemment en lien avec le premier mode de réalisation.

Le guide d'onde intégré 40 comporte ainsi une section de couplage 41, formée ici de deux transformateurs de mode 41.1, 41.2, et deux sections distales 43.1, 43.2, distinctes l'une de l'autre dans le sens où elles ne se rejoignent pas. Des sections courbes 42.1, 42.2 assurent la jonction entre les transformateurs de mode 41.1, 41.2 et les sections distales 43.1, 43.2 respectives. Les sections courbes 42.1, 42.2 sont agencées de sorte que le guide d'onde intégré 40 soit situé à distance, en projection orthogonale, des bras tenseurs 30, permettant ainsi de limiter la fuite du mode optique dans les bras tenseurs 30.

Dans la mesure où les réflecteurs optiques 52.1, 52.2, ici des miroirs de Bragg dont la longueur peut être de l'ordre de plusieurs dizaines de microns, par exemple 50$\mu$m voire davantage pour assurer une réflectivité élevée et une sélectivité en longueur d'onde, sont situés dans des sections distales 43 qui se s'étendent pas sous les bras tenseurs 30, grâce aux sections courbes 42, on obtient une source laser de type DBR à membrane suspendue à base de germanium dont les pertes optiques sont limitées. De plus, par le rayon de courbure des sections courbes 42 avantageusement compris entre $\lambda$/4 et 2$\lambda$, on maximise la longueur d'amplification optique et donc le gain modal, tout en limitant encore les pertes optiques.

Des modes de réalisation particuliers viennent d'être décrits. Différentes variantes et modifications apparaîtront à l'homme du métier. Ainsi, la source laser 1 selon le deuxième mode de réalisation peut présenter les différents types d'extraction lumineuse décrits précédemment, en fonction du coefficient de réflectivité des miroirs de Bragg, voire en fonction du caractère adiabatique et/ou du taux de couplage des transformateurs de mode. Il peut ainsi comporter, le cas échéant, un guide d'onde d'extraction tel que décrit précédemment, et la membrane suspendue peut comporter plusieurs portions centrales.

**Revendications**

1. Source laser (1), comportant :

   ○ une couche semiconductrice (10) réalisée à base de germanium, comportant une membrane suspendue au-dessus d'une couche support (3), la membrane suspendue étant formée :

• d'une portion centrale (20), contrainte en tension dans un plan parallèle à la couche support (3), comportant une section d'amplification optique (21) adaptée à produire un rayonnement lumineux par émission stimulée, et

• de plusieurs portions latérales (30) formant des bras tenseurs, opposées les unes aux autres vis-à-vis de la portion centrale (20), et agencées de manière à maintenir la portion centrale (20) suspendue et contrainte en tension, les bras tenseurs (30) présentant une largeur moyenne supérieure à une largeur moyenne de la portion centrale (20),

la source laser (1) comporte en outre :

○ un guide d'onde intégré (40), participant à former une cavité optique avec au moins la section d'amplification optique (21), situé au niveau de la couche support (3) et à distance de la membrane suspendue, et **caractérisé en ce qu'**il comporte:

• une section de couplage (41), située en regard de la section d'amplification optique (21), adaptée à permettre le couplage optique à celle-ci par onde évanescente, et
• au moins une section courbe (42), prolongeant la section de couplage (41), et agencée de sorte que le guide d'onde intégré (40) soit disposé à distance, en projection orthogonale, des bras tenseurs (30).

**2.** Source laser (1) selon la revendication 1, adaptée à émettre un rayonnement lumineux de longueur d'onde d'émission $\lambda$, dans laquelle le guide d'onde intégré (40) présente une distance minimale ($d_{min}$) vis-à-vis des bras tenseurs (30), en projection orthogonale, supérieure ou égale à $\lambda/4$.

**3.** Source laser (1) selon la revendication 1 ou 2, adaptée à émettre un rayonnement lumineux de longueur d'onde d'émission $\lambda$, dans laquelle la section courbe (42) présente un rayon de courbure moyen (R) supérieur ou égal à $\lambda/4$.

**4.** Source laser (1) selon l'une quelconque des revendications 1 à 3, adaptée à émettre un rayonnement lumineux de longueur d'onde d'émission $\lambda$, dans laquelle la section courbe (42) présente un rayon de courbure moyen (R) inférieur ou égal à $2\lambda$.

**5.** Source laser (1) selon l'une quelconque des revendications 1 à 4, dans laquelle le guide d'onde intégré (40) présente une forme longitudinale en anneau, et comporte deux sections courbes (42) prolongeant la section de couplage (41) et situées de part et d'autre de celui-ci, et une section dite distale (43), reliée à la section de couplage (41) par les sections courbes (42).

**6.** Source laser (1) selon l'une quelconque des revendications 1 à 4, dans laquelle le guide d'onde intégré (40) présente une forme longitudinale dite ouverte, et comporte une première section dite distale (43.1), reliée à la section de couplage (41) par la section courbe (42.1) et comprenant un premier réflecteur optique (52.1).

**7.** Source laser (1) selon la revendication 6, comportant un deuxième réflecteur optique (52.2) situé dans un bras tenseur (30.2) opposé au bras tenseur (30.1) à proximité duquel est située la première section distale (43.1), de sorte que la cavité optique est définie par le premier réflecteur optique (52.1) situé dans la première section distale (43.1) et par le deuxième réflecteur optique (52.2) situé dans le deuxième bras tenseur (30.2).

**8.** Source laser (1) selon la revendication 6, dans laquelle le guide d'onde intégré (40) comporte une deuxième section distale (43.2) comprenant un deuxième réflecteur optique (52.2), distincte de la première section distale (43.1), et reliée à la section de couplage (41) par une deuxième section courbe (42.2), de sorte que la cavité optique est définie par le premier réflecteur optique (52.1) situé dans la première section distale (43.1) et par le deuxième réflecteur optique (52.2) situé dans la deuxième section distale (43.2).

**9.** Source laser (1) selon l'une quelconque des revendications 1 à 8, dans laquelle la section de couplage (41) comporte au moins une zone de couplage (41.1, 41.2 ; 44.1, 44.2) qui présente une dimension transversale qui varie suivant l'axe longitudinal du guide d'onde intégré (40), de sorte qu'un indice effectif du mode optique supporté par la section de couplage (41) passe localement d'une valeur supérieure à un indice effectif du mode optique supporté par la section d'amplification optique (21) à une valeur inférieure à celui-ci.

**10.** Source laser (1) selon la revendication 9, dans laquelle la zone de couplage (41.1, 41.2) forme un transformateur de mode adiabatique.

**11.** Source laser (1) selon la revendication 9 ou 10, dans laquelle la zone de couplage (41.1, 41.2 ; 44.1, 44.2) présente un couplage partiel de manière à permettre une extraction du rayonnement lumineux hors de la cavité optique par la membrane suspendue, ou présente un couplage total de manière à permettre une extraction du rayonnement lumineux hors de la cavité optique au moyen d'un guide d'onde d'extraction (51) situé au niveau de la couche support (3) et couplé optiquement au guide d'onde intégré (40).

12. Source laser (1) selon l'une quelconque des revendications 1 à 11, dans laquelle la membrane suspendue comporte deux zones (32, 33) dopées selon des types de conductivité opposés s'étendant au moins en partie dans les portions latérales (30) de part et d'autre de la section d'amplification optique (21), celle-ci comportant un matériau (22) non intentionnellement dopé ou dopé de type n.

13. Source laser (1) selon la revendication 12, dans laquelle le guide d'onde intégré (40) est situé à distance, en projection orthogonale, desdites zones dopées (32, 33).

14. Source laser (1) selon l'une quelconque des revendications 1 à 13, dans laquelle la portion centrale (20) présente des contraintes mécaniques moyennes en tension, d'une valeur suffisante pour rendre sensiblement directe sa structure de bandes d'énergie au niveau de la section d'amplification optique (21).

15. Procédé de fabrication d'une source laser (1) selon l'une quelconque des revendications précédentes, comportant les étapes suivantes :

> i. réalisation du guide d'onde intégré (40) dans la couche support (3) ;
> ii. réalisation de la couche semiconductrice (10) comportant la membrane formée de la portion centrale (20) et des bras tenseurs (30), de sorte que la section de couplage (41) soit située en regard de la section d'amplification optique (21) et que les bras tenseurs (30) soient situés à distance, en projection orthogonale, du guide d'onde intégré (40) ;
> iii. mise en suspension de la membrane, de sorte que la portion centrale (20) soit contrainte en tension par les bras tenseurs (30).

**Patentansprüche**

1. Laserquelle (1), umfassend:

> ∘ eine Halbleiterschicht (10), die auf der Basis von Germanium hergestellt ist, umfassend eine Hängemembran über einer Trägerschicht (3), wobei die Hängemembran gebildet ist aus:
>
> > • einem zentralen Abschnitt (20), der in einer Ebene parallel zur Trägerschicht (3) unter Spannung gehalten wird, umfassend eine Sektion zur optischen Verstärkung (21), die dafür geeignet ist, eine Lichtstrahlung durch stimulierte Emission zu erzeugen, und
> • mehreren lateralen Abschnitten (30), welche Spannarme bilden, die in Bezug auf den zentralen Abschnitt (20) einander gegenüberliegen und eingerichtet sind, den zentralen Abschnitt (20) aufgehängt und unter Spannung gehalten aufrechtzuerhalten, wobei die Spannarme (30) eine mittlere Breite aufweisen, die größer ist als eine mittlere Breite des zentralen Abschnitts (20),

wobei die Laserquelle (1) außerdem umfasst:

> ∘ einen integrierten Wellenleiter (40), der an der Bildung eines optischen Hohlraums mit mindestens der Sektion zur optischen Verstärkung (21) beteiligt ist, und der auf der Höhe der Trägerschicht (3) und in einer Distanz von der Hängemembran angeordnet ist, **dadurch gekennzeichnet, dass** er umfasst:
>
> > • eine Kopplungssektion (41), die gegenüber der Sektion zur optischen Verstärkung (21) angeordnet ist, und die dafür geeignet ist, die optische Kopplung mit dieser durch eine abklingende Welle zu gestatten, und
> > • mindestens eine Krümmungssektion (42), welche die Kopplungssektion (41) verlängert und derart eingerichtet ist, dass der integrierte Wellenleiter (40) in einer Distanz, in der orthogonalen Projektion, der Spannarme (30) angeordnet ist.

2. Laserquelle (1) nach Anspruch 1, welche dafür geeignet ist, eine Lichtstrahlung mit der Emissionswellenlänge $\lambda$ zu emittieren, wobei der integrierte Wellenleiter (40) eine minimale Distanz ($d_{min}$) in Bezug auf die Spannarme (30), in der orthogonalen Projektion, aufweist, die größer oder gleich $\lambda/4$ ist.

3. Laserquelle (1) nach Anspruch 1 oder 2, welche dafür geeignet ist, eine Lichtstrahlung mit der Emissionswellenlänge $\lambda$ zu emittieren, wobei die Krümmungssektion (42) einen mittleren Krümmungsradius (R) aufweist, der größer oder gleich $\lambda/4$ ist.

4. Laserquelle (1) nach einem der Ansprüche 1 bis 3, welche dafür geeignet ist, eine Lichtstrahlung mit der Emissionswellenlänge $\lambda$ zu emittieren, wobei die Krümmungssektion (42) einen mittleren Krümmungsradius (R) aufweist, der größer oder gleich $2\lambda$ ist.

**5.** Laserquelle (1) nach einem der Ansprüche 1 bis 4, wobei der integrierte Wellenleiter (40) eine longitudinale Ringform aufweist, und zwei Krümmungssektionen (42), welche die Kopplungssektion (41) verlängern und auf beiden Seiten von dieser angeordnet sind, und eine als distal bezeichnete Sektion (43), die mit der Kopplungssektion (41) durch die Krümmungssektionen (42) verbunden ist, umfasst.

**6.** Laserquelle (1) nach einem der Ansprüche 1 bis 4, wobei der integrierte Wellenleiter (40) eine als offen bezeichnete longitudinale Form aufweist, und eine erste als distal bezeichnete Sektion (43.1) umfasst, die mit der Kopplungssektion (41) durch die Krümmungssektion (42.1) verbunden ist und einen ersten optischen Reflektor (52.1) umfasst.

**7.** Laserquelle (1) nach Anspruch 6, umfassend einen zweiten optischen Reflektor (52.2), der in einem Spannarm (30.2) gegenüber dem Spannarm (30.1) angeordnet ist, in der Nähe von welchem die erste distale Sektion (43.1) derart angeordnet ist, dass der optische Hohlraum durch den ersten optischen Reflektor (52.1), der in der ersten distalen Sektion (43.1) angeordnet ist, und durch den zweiten optischen Reflektor (52.2), der in dem zweiten Spannarm (30.2) angeordnet ist, definiert wird.

**8.** Laserquelle (1) nach Anspruch 6, wobei der integrierte Wellenleiter (40) eine zweite distale Sektion (43.2) umfasst, die einen zweiten optischen Reflektor (52.2) umfasst, die von der ersten distalen Sektion (43.1) verschieden ist, und die mit der Kopplungssektion (41) durch eine zweite Krümmungssektion (42.2) derart verbunden ist, dass der optische Hohlraum durch den ersten optischen Reflektor (52.1), der in der ersten distalen Sektion (43.1) angeordnet ist, und durch den zweiten optischen Reflektor (52.2), der in der zweiten distalen Sektion (43.2) angeordnet ist, definiert wird.

**9.** Laserquelle (1) nach einem der Ansprüche 1 bis 8, wobei die Kopplungssektion (41) mindestens eine Kopplungszone (41.1, 41.2; 44.1, 44.2) umfasst, welche eine Querabmessung aufweist, die gemäß der Longitudinalachse des integrierten Wellenleiters (40) derart variiert, dass ein effektiver Index des optischen Modus, der von der Kopplungssektion (41) getragen wird, lokal von einem Wert, welcher größer ist als ein effektiver Index des optischen Modus, der von der optischen Verstärkungssektion (21) getragen wird, zu einem Wert, welcher kleiner ist als dieser, übergeht.

**10.** Laserquelle (1) nach Anspruch 9, wobei die Kopplungszone (41.1, 41.2) einen Transformator mit adiabatischem Modus bildet.

**11.** Laserquelle (1) nach Anspruch 9 oder 10, wobei die Kopplungszone (41.1, 41.2; 44.1, 44.2) eine partielle Kopplung aufweist, um eine Extraktion der Lichtstrahlung aus dem optischen Hohlraum durch die Hängemembran zu gestatten, oder eine totale Kopplung aufweist, um eine Extraktion der Lichtstrahlung aus dem optischen Hohlraum mit Hilfe eines Extraktionswellenleiters (51) zu gestatten, der auf der Höhe der Trägerschicht (3) angeordnet ist und optisch mit dem integrierten Wellenleiter (40) gekoppelt ist.

**12.** Laserquelle (1) nach einem der Ansprüche 1 bis 11, wobei die Hängemembran zwei Zonen (32, 33) aufweist, die gemäß entgegengesetzten Leitfähigkeitstypen dotiert sind, und die sich mindestens teilweise in die lateralen Abschnitte (30) auf beiden Seiten der optischen Verstärkungssektion (21) erstrecken, wobei diese ein Material (22) umfasst, das nicht beabsichtigt dotiert oder n-Typ-dotiert ist.

**13.** Laserquelle (1) nach Anspruch 12, wobei der integrierte Wellenleiter (40) in einer Distanz, in der orthogonalen Projektion, von den dotierten Zonen (32, 33) angeordnet ist.

**14.** Laserquelle (1) nach einem der Ansprüche 1 bis 13, wobei der zentrale Abschnitt (20) mittlere mechanische Zugspannung mit einem ausreichenden Wert aufweist, um seine Energiebänderstruktur auf der Höhe der optischen Verstärkungssektion (21) im Wesentlichen direkt auszubilden.

**15.** Verfahren zur Herstellung einer Laserquelle (1) nach einem der vorhergehenden Ansprüche, umfassend die folgenden Schritte:

> i. Herstellen des integrierten Wellenleiters (40) in der Trägerschicht (3);
> ii. Herstellen der Halbleiterschicht (10), umfassend die Membran, die aus dem zentralen Abschnitt (20) und den Spannarmen (30) gebildet ist, derart, dass die Kopplungssektion (41) gegenüber der optischen Verstärkungssektion (21) angeordnet ist, und dass die Spannarme (30) in einer Distanz, in der orthogonalen Projektion, des integrierten Wellenleiters (40) angeordnet sind;
> iii. Aufhängen der Membran derart, dass der zentrale Abschnitt (20) unter Spannung von den Spannarmen (30) gehalten wird.

**Claims**

**1.** Laser source (1), comprising:

> ○ a germanium-based semiconductor layer (10) comprising a membrane suspended above a carrier layer (3), the suspended membrane being formed:

> • of a central portion (20), which is tensilely stressed in a plane parallel to the carrier layer (3), comprising an optical amplification section (21) that is suitable for producing light radiation by stimulated emission, and
> • of a plurality of lateral portions (30) forming tensioning arms that are opposite one another with respect to the central portion (20), and that are arranged so as to keep the central portion (20) suspended and tensilely stressed, the tensioning arms (30) having an average width larger than an average width of the central portion (20),

the laser source (1) furthermore comprises:

> ◦ an integrated waveguide (40) that participates in forming an optical cavity with at least the optical amplification section (21), said integrated waveguide being located level with the carrier layer (3) and at distance from the suspended membrane, and **characterized in that** it comprises:

>> • a coupling section (41), which is located facing the optical amplification section (21), and which is suitable for allowing evanescent-wave optical coupling to the latter, and
>> • at least one curved section (42) that extends the coupling section (41), and which is arranged so that the integrated waveguide (40) is placed at distance, in orthogonal projection, from the tensioning arms (30).

2. Laser source (1) according to Claim 1, suitable for emitting light radiation of emission wavelength $\lambda$, wherein the integrated waveguide (40) has a minimum distance ($d_{min}$) with respect to the tensioning arms (30), in orthogonal projection, larger than or equal to $\lambda/4$.

3. Laser source (1) according to Claim 1 or 2, suitable for emitting light radiation of emission wavelength $\lambda$, wherein the curved section (42) has an average radius of curvature (R) larger than or equal to $\lambda/4$.

4. Laser source (1) according to any one of Claims 1 to 3, suitable for emitting light radiation of emission wavelength $\lambda$, wherein the curved section (42) has an average radius of curvature (R) smaller than or equal to $2\lambda$.

5. Laser source (1) according to any one of Claims 1 to 4, wherein the integrated waveguide (40) has a ring longitudinal shape, and comprises two curved sections (42), which extend the coupling section (41) and are located on either side thereof, and what is called a distal section (43), which is connected to the coupling section (41) by the curved sections (42).

6. Laser source (1) according to any one of Claims 1 to 4, wherein the integrated waveguide (40) has what is called an open longitudinal shape, and comprises a first what is called distal section (43.1), which is connected to the coupling section (41) by the curved section (42.1), and which comprises a first optical reflector (52.1).

7. Laser source (1) according to Claim 6, comprising a second optical reflector (52.2) located in a tensioning arm (30.2) opposite to the tensioning arm (30.1) in proximity to which the first distal section (43.1) is located, so that the optical cavity is defined by the first optical reflector (52.1) located in the first distal section (43.1) and by the second optical reflector (52.2) located in the second tensioning arm (30.2).

8. Laser source (1) according to Claim 6, wherein the integrated waveguide (40) comprises a second distal section (43.2) comprising a second optical reflector (52.2), said second distal section being separate from the first distal section (43.1) and connected to the coupling section (41) by a second curved section (42.2), so that the optical cavity is defined by the first optical reflector (52.1) located in the first distal section (43.1) and by the second optical reflector (52.2) located in the second distal section (43.2).

9. Laser source (1) according to any one of Claims 1 to 8, wherein the coupling section (41) comprises at least one coupling zone (41.1, 41.2; 44.1, 44.2) that has a transverse dimension that varies along the longitudinal axis of the integrated waveguide (40), so that an effective index of the optical mode supported by the coupling section (41) passes locally from a value higher than an effective index of the optical mode supported by the optical amplification section (21) to a value lower than the effective index of the optical mode supported by the optical amplification section.

10. Laser source (1) according to Claim 9, wherein the coupling zone (41.1, 41.2) forms an adiabatic mode transformer.

11. Laser source (1) according to Claim 9 or 10, wherein the coupling of the coupling zone (41.1, 41.2; 44.1, 44.2) is partial, so as to allow the light radiation to be extracted out of the optical cavity via the suspended membrane, or complete, so as to allow light radiation to be extracted out of the optical cavity by means of an extracting waveguide (51) located level with the carrier layer (3) and optically coupled to the integrated waveguide (40).

**12.** Laser source (1) according to any one of Claims 1 to 11, wherein the suspended membrane comprises two zones (32, 33) that are doped with opposite conductivity types extending at least partially into the lateral portions (30) on either side of the optical amplification section (21), the latter comprising a material (22) that is unintentionally doped or doped n-type.

**13.** Laser source (1) according to Claim 12, wherein the integrated waveguide (40) is located at distance, in orthogonal projection, from said doped zones (32, 33).

**14.** Laser source (1) according to any one of Claims 1 to 13, wherein the central portion (20) has an average tensile mechanical stress of a sufficient value to make its energy-band structure substantially direct in the optical amplification section (21).

**15.** Process for fabricating a laser source (1) according to any one of the preceding claims, comprising the following steps:

i) producing the integrated waveguide (40) in the carrier layer (3);
ii) producing the semiconductor layer (10) comprising the membrane formed in the central portion (20) and tensioning arms (30), so that the coupling section (41) is located facing the optical amplification section (21) and so that the tensioning arms (30) are located at distance, in orthogonal projection, from the integrated waveguide (40);
iii) suspending the membrane, so that the central portion (20) is tensilely stressed by the tensioning arms (30).

**Fig.1**

**Fig.2A**

**Fig.2B**

**Fig.3A**

**Fig.3B**

**Fig.4**

**Fig.5A**

**Fig.5B**

**Fig.5C**

**Fig.6A**

7

3.1

2

**Fig.6B**

40

3.1

2

**Fig.6C**

40

3.2

3.1

2

**Fig.6D**

42    43    41    42

40

3.2

**Fig.6E**

12

8

**Fig.6F**

13

12

8

**Fig.6G**

40

10

13

4

3.2

3

3.1

2

**Fig.6H**

**Fig.6I**

**Fig.7A**

**Fig.7B**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3151266 A1
- EP 3151265 A

**Littérature non-brevet citée dans la description**

- **PETYKIEWICZ et al.** Direct Bandgap Light Emission from Strained Ge Nanowires. *Nano Lett.,* 2016, vol. 16 (4), 2168-2173
- **SÜESS et al.** Analysis of enhanced light emission from highly strained germanium microbridges. *Nature Photon.,* 2013, vol. 7, 466-472
- **GUILLOY et al.** Germanium under high tensile stress: Nonlinear dependence of direct band gap vs strain. *ACS Photonics,* 2016, vol. 3, 1907-1911
- **SUN et al.** Adiabaticity criterion and the shortest adiabatic mode transformer in a coupled-waveguide system. *Opt. Lett.,* 2009, vol. 34, 280